# EUROPEAN PATENT SPECIFICATION

(11) **EP 2 879 295 B1**
(45) Date of publication and mention of the grant of the patent: **04.09.2019**
(21) Application number: 13822911.7
(22) Date of filing: 26.07.2013
(51) Int. Cl.: H03M 13/11, H03M 13/27, H03M 13/25

(54) **TRANSMISSION METHOD, RECEPTION METHOD, TRANSMITTER, AND RECEIVER**
SENDEVERFAHREN, EMPFANGSVERFAHREN, SENDER UND EMPFÄNGER
PROCÉDÉ D'ÉMISSION, PROCÉDÉ DE RÉCEPTION, ÉMETTEUR, ET RÉCEPTEUR

(30) Priority: 27.07.2012 EP 12178270; 27.07.2012 EP 12178271
(43) Date of publication of application: 03.06.2015
(73) Proprietor: Sun Patent Trust, New York, NY 10017 (US)
(72) Inventor: PETROV, Mihail, 63225 Langen (DE)
(74) Representative: Grünecker Patent- und Rechtsanwälte PartG mbB
(86) International application number: PCT/JP2013/004551
(87) International publication number: WO 2014/017102

(56) References cited:
- EP-A1- 2 013 976
- EP-A1- 2 214 319
- WO-A1-2010/039257
- WO-A1-2012/098984
- WO-A2-2010/083038
- JP-A- 2011 514 090
- JP-B2- 4 788 650
- Catherine Douillard ET AL: "The Bit Interleaved Coded Modulation Module for DVB-NGH", Telecommunications (ICT), 2012 19th International Conference on, 25 April 2012 (2012-04-25), pages 1-6, XP055041408, Piscataway, NJ, US DOI: 10.1109/ICTEL.2012.6221327 ISBN: 978-1-46-730745-1 Retrieved from the Internet: URL:http://ieeexplore.ieee.org/stamp/stamp .jsp?arnumber=06221327 [retrieved on 2012-10-17]
- FRANK KIENLE ET AL: "Macro Interleaver Design for Bit Interleaved Coded Modulation with Low-Density Parity-Check Codes", VEHICULAR TECHNOLOGY CONFERENCE, 2008. VTC SPRING 2008. IEEE, IEEE, PISCATAWAY, NJ, USA, 11 May 2008 (2008-05-11), pages 763-766, XP031255631, ISBN: 978-1-4244-1644-8
- DVB ORGANIZATION: "TM-NGH1172_Details_TI_FhG.ppt", DVB, DIGITAL VIDEO BROADCASTING, C/O EBU - 17A ANCIENNE ROUTE - CH-1218 GRAND SACONNEX, GENEVA - SWITZERLAND, 22 September 2011 (2011-09-22), XP017836692,
- DOUILLARD, C.: 'The Bit Interleaved coded Modulation module for DVB-NGH' ENHANCED FEATURES FOR MOBILE RECEPTION, TELECOMMUNICATIONS(ICT), 2012 19TH INTERNATIONAL CONFERENCE 25 April 2012, XP055041408
- 'Digital Video Broadcasting(DVB) Frame structure channel coding and modulation for a second generation digital terrestrial television broadcasting system(DVB-T2)' ETSI EN 302 755 V1.3.1 vol. 302, no. 755, 12 April 2012, pages 45 - 50, XP014069715

## Description

### [Background Art]

The present invention relates to the field of digital communications, and more specifically to a communication system that employs rotated constellations in conjunction with quasi-cyclic low-density parity-check codes (QC-LDPC codes).

### [Background Art]

In recent years, transmitters for example interleave codeword bits, and then map the interleaved codeword bits to real-valued symbols, and multiply a D-dimensional vector by an orthogonal matrix with D rows and D columns for each D real-valued symbols (perform a rotation) (for example, see the DVB-T2 standard, ETSI EN 302 755 V1.1.1).

The article "The Bit Interleaved Coded Modulation module for DVB-NGH: Enhanced features for mobile reception" by Catherine Douillard et al. (Telecommunications (ICT), 2012 19th International Conference on, Piscataway, NJ, US) describes the main features of the DVB-NGH Bit-Interleaved Coded Modulation (BICM) module. This latter is derived from a subset of DVB-T2 BICM components with additional features intended to first lower receiver complexity and power consumption and then to increase receiver robustness over mobile reception. According to this article, the principle of signal space diversity is extended to four-dimensional rotated constellations and the interleaving depth is increased in order to provide mobility over terrestrial and satellite links.

The article "Macro Interleaver Design for Bit Interleaved Coded Modulation with Low-Density Parity-Check Codes" by Frank Kienle et al. (IEEE VEHICULAR TECHNOLOGY CONFERENCE, 2008, PISCATAWAY, NJ, USA) discloses a specific example of an interleaver for 16-QAM, wherein each real-valued constellation word is made up of four bits from four distinct cyclic blocks.

### [Citation List]

### [Non-Patent Literature]

[Non-Patent Literature 1] ETSI EN 302 755 V1.1.1 (DVB-T2 standard)
[Non-Patent Literature 2] ETSI EN 302 307 V1.1.1 (DVB-S2 standard)
[Non-Patent Literature 3] ETSI EN 302 769 V1.1.1 (DVB-C2 standard)

### [Summary of Invention]

### [Technical Problem]

In the case where a rotation is performed on the transmission side, interleaving of codeword bits without consideration of the number of dimensions D might complicate the configuration of a receiver.

In view of this, the present invention aims to provide a transmission method that includes a new interleaving of codeword bits that can avoid complexity in the configuration of a receiver.

This is achieved by the features of the independent claims. Preferred embodiments are the subject matter of dependent claims.

### [Advantageous Effects of Invention]

According to the present invention, it is possible to avoid complexity in the configuration of a receiver, irrespective of the number of dimensions D used by the receiver.

### [Brief Description of Drawings]

FIG. 1 is a block diagram showing the configuration of a generic transmitter that employs rotated constellations in conjunction with QC-LDPC codes.
FIG. 2 shows an example of a parity-check matrix (PCM) of a QC-LDPC code.
FIG. 3 shows an example of a bit interleaver for QC-LDPC codes.
FIG. 4 shows an example of section permutation in FIG. 3.
FIG. 5 shows an example of writing a plurality of bits of a low-density parity-check codeword (LDPC codeword) into a section permutation matrix in part (a) and an example of reading out the bits of the LDPC codeword from the section permutation matrix in part (b).
FIG. 6 shows an example of a bit interleaver that is equivalent to a bit interleaver in FIG. 3 to which two types of permutation functions are added.
FIG. 7 shows an example of writing a plurality of bits of an LDPC codeword into a section permutation matrix in part (a), an example of reading out the bits of the LDPC codeword from the section permutation matrix in part (b), an example of mapping four bits of a quasi-cyclic low-density parity-check block (QC-LDPC block) to a 16 quadrature amplitude modulation constellation (16-QAM constellation) in part (c), an example of output from a QAM mapper in part (d), and an example of mapping a pair of four-dimensional rotated constellations to four adjacent complex symbols (cells) in part (e).
FIG. 8 shows an example of mapping an output from a bit interleaver to a non-rotated constellation.
FIG. 9 shows an example of mapping an output from a bit interleaver to a constellation block.
FIG. 10A is a block diagram showing a general receiver that employs non-iterative decoding.
FIG. 10B is a block diagram showing a general receiver that employs iterative decoding.
FIG. 11 is a more detailed block diagram showing an iterative decoder in FIG. 10B.
FIG. 12 shows the configuration of a parallel iterative decoder for QC-LDPC codes.
FIG. 13 shows the configuration of a parallel non-iterative decoder for QC-LDPC codes.
FIG. 14 shows a storage example of (soft) bits of an LDPC block in memory banks.
FIG. 15 shows a storage example of received complex symbols (cells) in the memory banks.
FIG. 16 shows an example of the compact and regular hardware configuration of an iterative decoder.
FIG. 17 shows an example of mapping an LDPC block to a constellation block relating to an embodiment of the present invention.
FIG. 18 is a block diagram showing a transmitter relating to the embodiment of the present invention.
FIG. 19A shows an example of mapping two multi-dimensional rotated vectors to complex symbols.
FIG. 19B shows another example of mapping two multi-dimensional rotated vectors to complex symbols.
FIG. 19C shows further another example of mapping two multi-dimensional rotated vectors to complex symbols.
FIG. 20 shows an example of mapping bits output from a bit interleaver to a constellation block performed by the transmitter in FIG. 18.
FIG. 21A shows the details of (Step 2) and (Step 4) of QAM mapping in FIG. 20.
FIG. 21B shows the details of (Step 3) and (Step 4) of constellation rotation in FIG. 20.
FIG. 22 shows an example of mapping PAM symbols to a non-rotated constellation.
FIG. 23A is a block diagram showing a receiver that employs non-iterative decoding relating to the embodiment of the present invention.
FIG. 23B is a block diagram showing a receiver that employs iterative decoding relating to the embodiment of the present invention.
FIG. 24 is another block diagram showing the configuration of a generic transmitter that employs rotated constellations in conjunction with QC-LDPC codes.
FIG. 25 is a block diagram showing a transmitter relating to another embodiment of the present invention.
FIG. 26 shows in parts (a) to (c) an example of processing performed by a component deinterleaver in FIG. 25.
FIG. 27 shows in parts (a) to (c) another example of the processing performed by the component deinterleaver in FIG. 25.
FIG. 28 shows in parts (a) and (b) an example of processing performed by a cell interleaver in FIG. 25.
FIG. 29 shows in parts (a) and (b) another example of the processing performed by the cell interleaver in FIG. 25.
FIG. 30A and FIG. 30B each show an example of output from the cell interleaver in FIG. 25. FIG. 31A is a block diagram showing another transmitter relating to the other embodiment of the present invention.
FIG. 31B is a block diagram showing further another transmitter relating to the other embodiment of the present invention.
FIG. 32 is a block diagram showing a receiver relating to the other embodiment of the present invention.
FIG. 33A is a block diagram showing a receiver that employs iterative decoding relating to the other embodiment of the present invention.
FIG. 33B is a block diagram showing a decoder that employs simplified iterative decoding.
FIG. 33C is a detailed block diagram showing implementation of a component interleaver in FIG. 32.

### [Description of Embodiments]

### <Examination by the Inventor and Embodiment (1)>

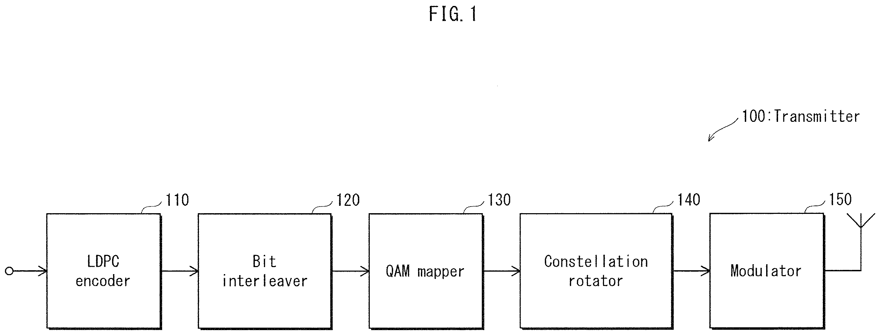

FIG. 1 is a block diagram showing the configuration of a generic transmitter 100 that employs rotated constellations in conjunction with QC-LDPC codes. The block diagram in FIG. 1 shows only blocks relevant to the present invention.

The transmitter 100 includes an LDPC encoder 110, a bit interleaver 120, a QAM mapper 130, a constellation rotator 140, and a modulator 150.

The transmitter 100 receives, as an input, binary blocks of a predetermined length, containing information to be transmitted. In the transmitter 100, the LDPC encoder 110 first encodes each information block using a low-density parity-check code (LDPC code) (for example, a QC-LDPC code including a repeat-accumulate quasi-cyclic low-density parity check code (RA-QC-LDPC code)). The encoding processing includes computation of redundancy bits and addition of the redundancy bits to the information block in order to make the information block more robust against errors.

Then, the bit interleaver 120 interleaves a plurality of bits of an LDPC codeword obtained by encoding (hereinafter, referred to as an LDPC block) (bit interleaving).

Next, the QAM mapper 130 maps the bit-interleaved bits of the LDPC block to complex quadrature amplitude modulation symbols (QAM symbols). Real and imaginary components of the complex QAM symbols are modulated independently. The real and the imaginary components are each obtained by encoding a predetermined number of bits, and the predetermined number is denoted here by B. Accordingly, the complex QAM symbol is obtained by encoding 2×B bits. The real and the imaginary components are each regarded as a pulse amplitude modulation symbol (PAM symbol) or an amplitude shift keying symbol (ASK symbol). This PAM symbol takes one value from a discrete set including 2^{B} values. How B bits are mapped to PAM symbols is well known, and is not directly relevant to the present invention. An aspect relevant to the present invention is that each FEC block is transformed into a block of (real) PAM symbols, each two of which constitute one complex QAM symbol.

Note that the QAM mapper 130 receives, as an input, a plurality of bits output from the bit interleaver 120, and maps each consecutive B bits to one PAM symbol thereby to consecutively output PAM symbols.

The QAM mapper 130 corresponds to a constellation mapper that performs a constellation mapping of each group of B bits of the interleaved FEC block to a real-valued symbol. The PAM symbol corresponds to the real-valued symbol.

In order to increase the robustness over fading channels, the constellation rotator 140 applies a dedicated transformation to a plurality of QAM symbols generated by the QAM mapper 130, and outputs a plurality of complex symbols. The transformation by the constellation rotator 140 is performed by grouping the QAM symbols into D QAM symbols and multiplying each D-dimensional vector having D PAM symbols as elements in each D QAM symbol by a square orthogonal matrix with D rows and D columns (D×D square orthogonal matrix). In other words, the constellation rotator 140 computes a D-dimensional rotated vector V_{R} = RV, where V is a D-dimensional vector, and R is a D×D square orthogonal matrix.

The pairs of D PAM symbols of each D-dimensional vector are regarded as identifying unique points in a D-dimensional space, the resulting D^{B} combinations forming a D-dimensional constellation. Accordingly, the matrix computation is regarded as a rotation in the D-dimensional space. A term "rotated constellation" is used as the rotation throughout this document. Only the above particular structure of the D×D square orthogonal matrix (rotation matrix) is not relevant to the present invention.

The orthogonal matrix used by the constellation rotator 140 is for example an orthogonal matrix in which values of elements in each dimension of D-dimensional vectors are spread over at least two dimensions.

Such an orthogonal matrix is for example a matrix in which absolute values of all elements on the main diagonal are equal to the first value, and absolute values of all elements out of the main diagonal are equal to the second value that is not zero, where the main diagonal is a diagonal with i rows and i columns (i = 1 to D). Note that the matrix whose D rows are permuted, the matrix whose D columns are permuted, or the matrix whose D rows and D columns are permuted may be used as the orthogonal matrix.

A specific example of this matrix is shown below.

An orthogonal matrix
[Equation 1] $R = \left(\begin{matrix}{s}_{1,1} a & {s}_{1,2} b & ⋯ & {s}_{1 , D} b \\ {s}_{2,1} b & {s}_{2,2} a & & ⋮ \\ ⋮ & & ⋱ & {s}_{D - 1 , D} b \\ {s}_{D , 1} b & ⋯ & {s}_{D , D - 1} b & {s}_{D , D} a\end{matrix}\right)$ satisfies the above Equation 1.

Here, a and b are each a real parameter. A sign value si,j satisfies the following equation.
[Equation 2] ${s}_{i , j} ∈ \left\{-1,+1\right\}$

The real parameters a and b satisfy the following equation.
[Equation 3] ${a}^{2} + \left(N-1\right) {b}^{2} = 1$ Here, b ≠ 0.

In order to achieve a high performance in the communication system that employs rotated constellations, it is necessary to map D transformed PAM symbols that are elements of each D-dimensional rotated vector (D components of each rotated constellation) to D different complex symbols. The complex symbols are also termed complex cells or cells. Furthermore, D components of each rotated constellation should preferably be spread in time and frequency such that channel fading that influences the D components is as uncorrelated as possible. These aspects are well known in this

### technical field.

Finally, the modulator 150 modulates the complex symbols, and the modulated complex symbols are transmitted on a communication medium. A modulation scheme to be used may be for example orthogonal frequency-division multiplexing (OFDM). Additional interleaving in time and frequency is generally performed prior to modulation in order to increase the diversity in the communication system.

One of the aims of the present invention is to disclose how the bit interleaver 120, which is provided between the LDPC encoder 110 and the QAM mapper 130, is optimized in order to allow an efficient implementation of a receiver in a system employing rotated constellations in conjunction with QC-LDPC codes.

The following describes some of characteristics of LDPC codes.

LDPC codes are linear error-correcting codes that are fully defined by a parity-check matrix (PCM), which is a binary sparse matrix that represents connection of bits of a codeword (also referred to as variable nodes) to parity checks (also referred to as check nodes). Columns and rows of the PCM correspond to the variable nodes and the check nodes, respectively. Connections of the variable nodes to the check nodes are represented by an element "1" (matrix element value "1") in the PCM.

QC-LDPC codes have a structure that is particularly suitable for hardware implementation. In fact, most of not all standards today use QC-LDPC codes. The PCM of such a QC-LDPC code has a special structure consisting of a plurality of circulant matrices. A circulant matrix is a square matrix in which each row is a cyclic shift of an element of the previous row with one position, and can have one, two, or more cyclically-shifted diagonals. The size of each circulant matrix is Q rows and Q columns (Q×Q), where Q is referred to as the cyclic factor of the LDPC code. Such a quasi-cyclic structure allows Q check nodes to be processed in parallel, and therefore QC-LDPC codes are clearly advantageous for an efficient hardware implementation.

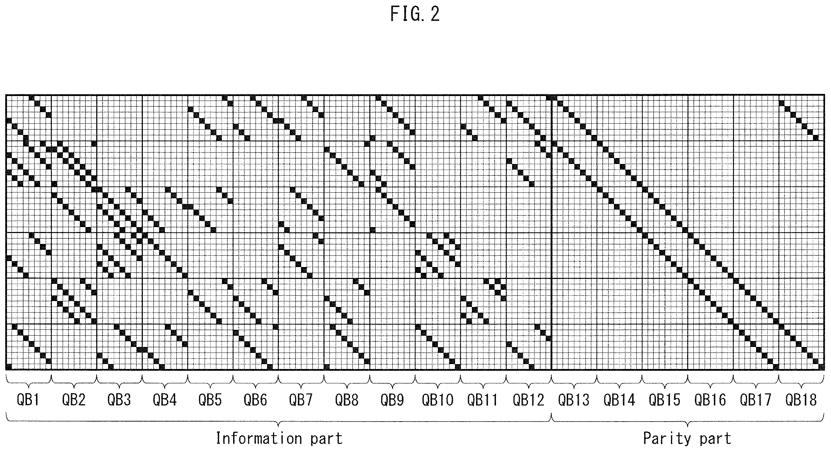

FIG. 2 shows an example of a PCM of an LDPC code with a cyclic factor Q = 8, the PCM having circulant matrices with one or two cyclically-shifted diagonals. In the PCM in FIG. 2, blackened squares each represent a matrix element having a value of one, and whitened squares each represent a matrix element having a value of zero.

The QC-LDPC code in FIG. 2 is a code for encoding a block of 8×12 = 96 bits to a codeword of 8×18 = 144 bits, having therefore a coding rate of 96/144 = 2/3. The bits of the codeword are divided into blocks of Q bits, which are referred to as cyclic blocks or quasi-cyclic blocks, and denoted by "QB" throughout this document.

The QC-LDPC code of the PCM in FIG. 2 belongs to a special family of QC-LDPC codes that are called RA-QC-LDPC codes. The RA-QC-LDPC codes are well known for their ease of encoding and are encountered in a large number of standards, such as the second-generation DVB standards including the DVB-S2 standard (see Non-Patent Literature 2), the DVB-T2 standard (see Non-Patent Literature 1), and the DVB-C2 standard (see Non-Patent Literature 3). For the RA-QC-LDPC codes, the right-hand side of the PCM, which corresponds to parity bits (parity part), has a staircase structure of the elements "1". These aspects are well known in this technical field. Note that the left-hand side of the PCM corresponds to information bits (information part).

Next, description is given on some of characteristics of a special type of a bit interleaver that is particularly adapted to the structure of the QC-LDPC block. This bit interleaver is referred to as a parallel bit interleaver, and is characterized in having a high degree of parallelism. The parallel bit interleaver particularly realizes an efficient hardware implementation.

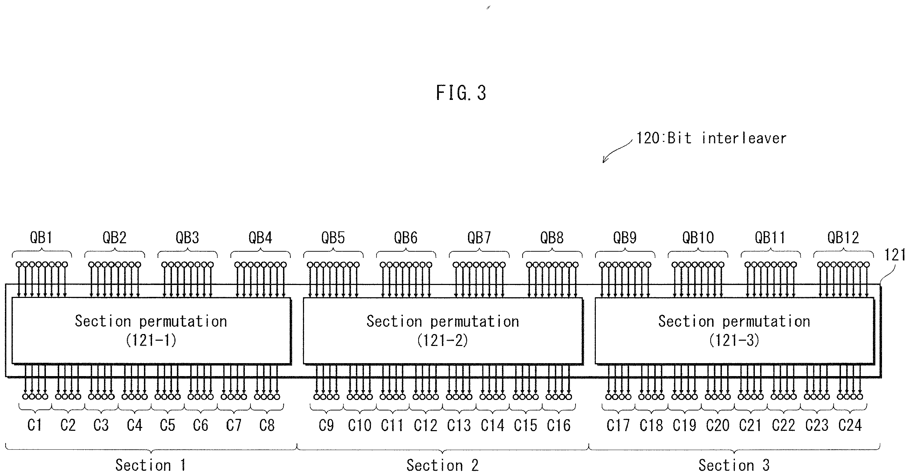

FIG. 3 shows an example of the bit interleaver 120 in FIG. 1, including a parallel bit interleaver 121 for QC-LDPC codes. The QC-LDPC code in this example has 12 QBs per codeword, and eight bits per QB (Q = 8). Note that the number of QBs per codeword is denoted by N throughout this document.

A plurality of QBs of one LDPC block are divided into a plurality of sections (referred to also as interleaver sections or the bit-interleaver sections in this document), and the sections are separately interleaved by section permutation. The section permutation may be applied to each section in accordance with the same rule. The number of QBs per section is a parameter of the parallel bit interleaver, and is denoted by M throughout this document. Also, M = 4 in the example in FIG. 3.

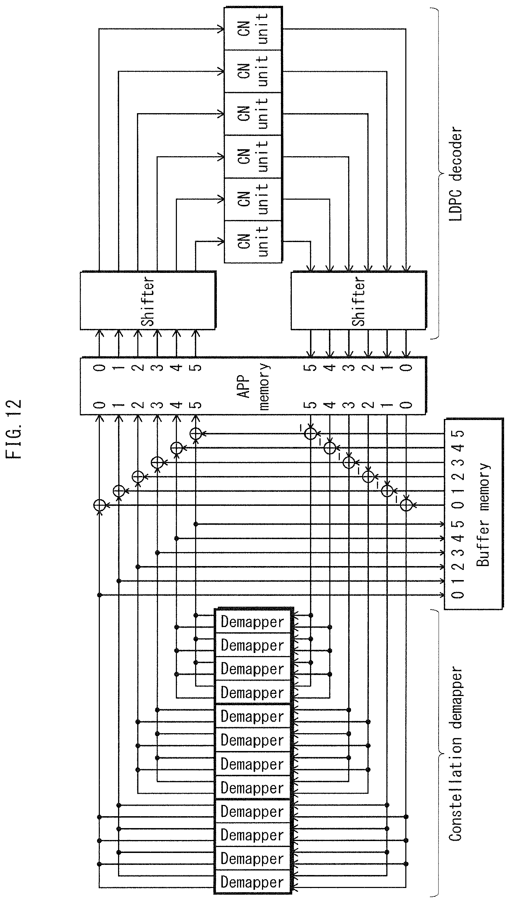

In the example in FIG. 3, 12 QBs QB1 to QB12 are divided into three sections 1 to 3. Respective Q×M = 8×4 bits of the sections 1 to 3 are separately interleaved by itnerleavers 121-1 to 121-3 included in the parallel bit interleaver 121 using section permutation. Note that the interleaving is performed such that one bit of each of M = 4 QBs included in the corresponding section is mapped to one of M = 4 bits of each of groups of bits C1 to C24.

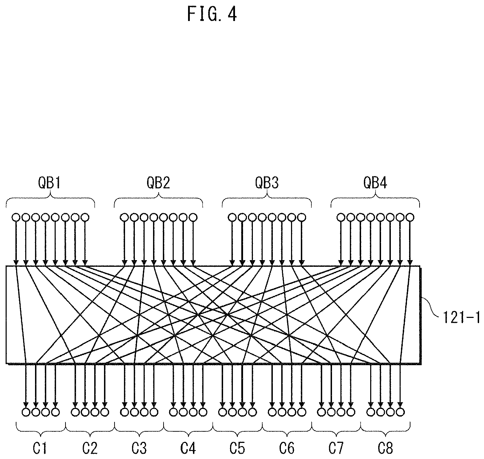

The following describes an example of a section permutation in the case of M = 4 and Q = 8 with reference to FIG. 4 targeting the section 1 in FIG. 3.

The section interleaver 121-1 performs bit interleaving as shown in FIG. 4 such that Q×M = 8×4 bits of the QBs QB1 to QB4 are mapped to Q = 8 groups of bits C1 to C8 which consist of M = 4 bits.

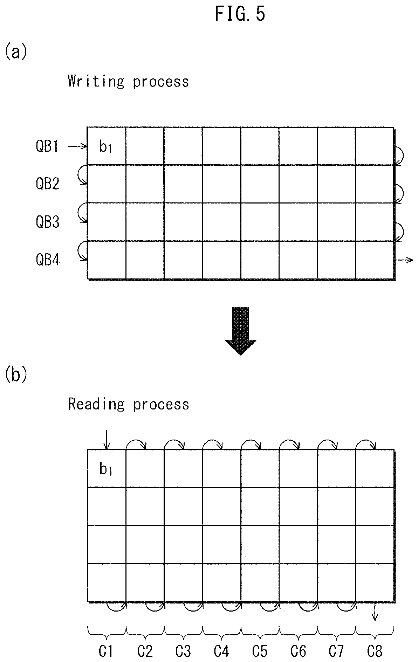

Moreover, further detailed description is given on section permutation in the case of M = 4 and Q = 8 with reference to parts (a) and (b) of FIG. 5 targeting the section 1 in FIG. 3. In parts (a) and (b) of FIG. 5, squares each represent one bit of a code block.

The section itnerleaver 121-1 performs processing equivalent to writing Q×M = 8×4 bits of the section 1 row by row into a matrix with Q = 8 columns and M = 4 rows (section permutation matrix) in the order of input as shown in part (a) in FIG. 5 and reading out the Q×M = 8×4 bits column by column from the matrix as shown in part (b) in FIG. 5. Note that the writing order and the reading order are each indicated by an arrow in parts (a) and (b) of FIG. 5, respectively.

Note that the interleaving described with reference to parts (a) and (b) of FIG. 5 is a so-called column-row interleaving.

As a result of the above section permutation, the output of the section interleaver consists of groups of M bits (bits of one column of the matrix), the M bits belonging to M different QBs of the original LDPC block.

Prior to the division of the QBs into the sections, the order of the QBs in the LDPC codeword may be changed according to a predetermined permutation. This permutation is referred to as quasi-cyclic block permutation (QB permutation). Moreover, an additional permutation may be applied to the Q bits of each QB in order to change the order of the Q bits of the QB. This permutation is referred to as intra-quasi-cyclic permutation (intra-QB permutation), and is typically a cyclic shift. Although a shift value is typically different for each cyclic block, the shift value may be the same.

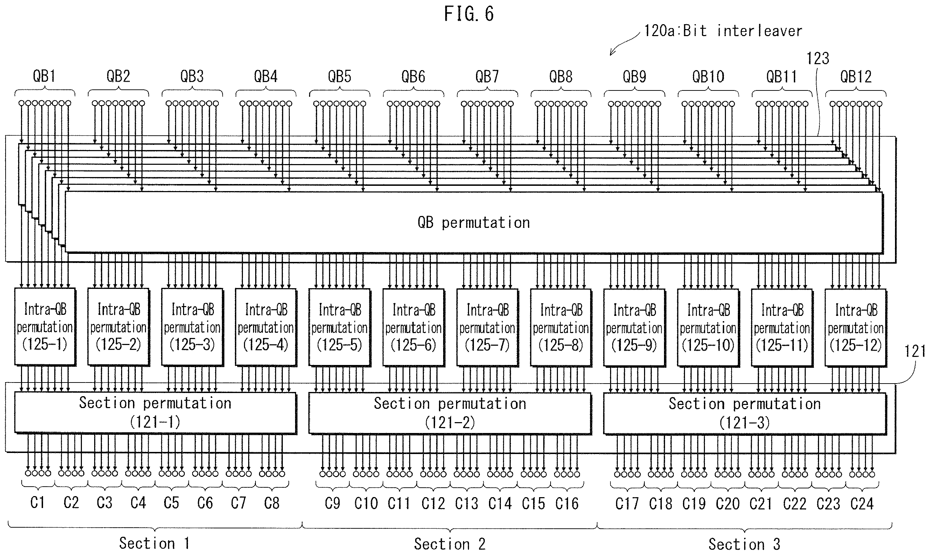

FIG. 6 shows a configuration example of a bit interleaver having a QB permutation function and an intra-QB permutation function.

The bit interleaver 120a includes, in addition to the section itnerleaver 121 which performs section permutation, a QB interleaver 123 that performs QB permutation and intra-QB interleavers 125-1 to 125-12 that perform intra-QB permutation, which are provided before the section itnerleaver 121.

Note that only one of the QB permutation and the intra-QB permutation may be performed. Alternatively, the QB permutation and the intra-QB permutation may be performed in the inverse order.

While the QB permutation and intra-QB permutation are important for optimization of the communication performance, they are not directly relevant to the present invention. In fact, the QB permutation and intra-QB permutation can be regarded as part of the LDPC code definition. The QB permutation is equivalent to a permutation of the columns of the QB in the original PCM. Also, a cyclic shift in the QB permutation (intra-QB cyclic shift) is equivalent to a cyclic shift of the original cyclic shift of the diagonals in the PCM by further qmodQ, where, q is a shift value for cyclic shift of Q bits in the intra-QB permutation. The same cyclic shift is applied to all diagonals of all QBs in the same column in the PCM.

Next, description is given on a method of mapping an LDPC block to QAM constellations.

This mapping method includes mapping each QAM constellation to two adjacent columns of a section permutation matrix. This is equivalent to that selection is performed such that the parameter M of the bit interleaver (the number of QBs per section) is equal to B (the number of bits per PAM symbol). Accordingly, each PAM symbol is modulated by consecutive B bits of one column of the section permutation matrix (see parts (a) and (b) of FIG. 5). This is a mapping method preferable for a regular (non-rotated) QAM constellation.

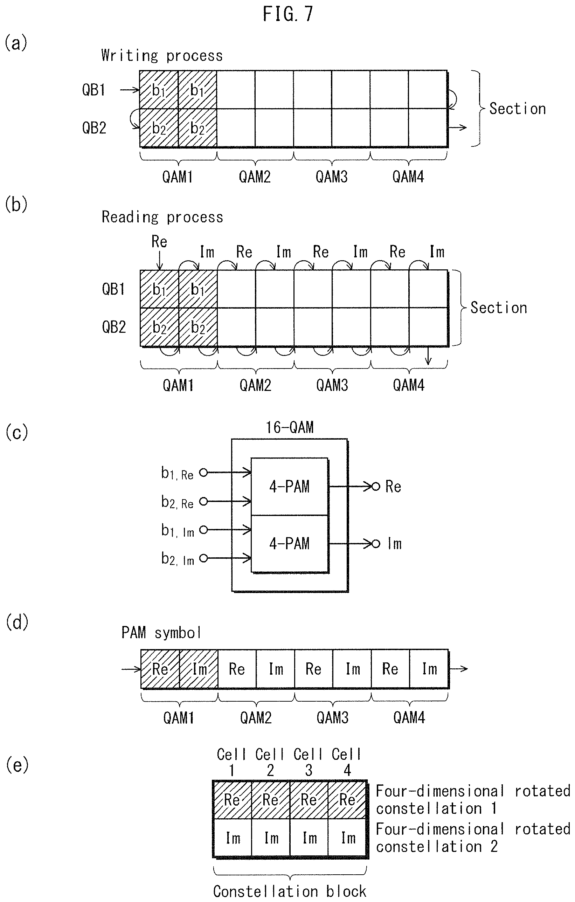

This example is described with reference to parts (a) to (d) of FIG. 7. Parts (a) to (d) of FIG. 7 relate to one section in the case of the cyclic factor Q = 8 and a 16-QAM constellation (consisting of two 4-PAMs and the number of bits of 4-PAM B = 2). In parts (a) and (b) of FIG. 7, squares each represent one bit of an LDPC codeword. Also, in part (d) of FIG. 7, squares each represent one PAM symbol (a real component or an imaginary component of a QAM symbol).

The bit interleaver 120 performs processing equivalent to writing Q×M = Q×B = 8×2 = 16 bits of each of the sections row by row into a matrix with Q columns and M rows = Q columns and B rows = eight columns and two rows in the order of input as shown in part (a) of FIG. 7 and reading out the written 16 bits column by column from this matrix as shown in part (b) of FIG. 7. Note that the writing order and the reading order are each indicated by an arrow in parts (a) and (b) of FIG. 7, respectively.

Then, as shown in part (c) of FIG. 7, the QAM mapper 130 generates and outputs a real component (4-PAM) of a QAM symbol from two bits of the first column of this matrix, and subsequently generates and outputs an imaginary component (4-PAM) of the QAM symbol from two bits of the second column of the matrix. This processing is repeatedly performed, and as a result the output from the QAM mapper 130 is as shown in part (d) of FIG. 7.

Note that Q generally has an extremely great value. In the DVB-T2 standard for example, Q = 360.

In the case where rotated constellations are employed, the constellation rotator 140 applies a first rotation to D PAM symbols (components) of D adjacent QAM symbols which are output from the QAM mapper 130, and applies a second rotation to remaining D components of the same D QAM symbols. Then, the constellation rotator 140 outputs a complex symbol (cell) that consists of a result of the first rotation as a real component and a result of the second rotation as an imaginary component. The constellation rotator 140 should preferably apply one of the two rotations to one type of D real components of D adjacent QAM symbols and apply the other rotation to D imaginary components of the same D QAM symbols. The case of D = 4 as an example of this rotation is shown in part (e) of FIG. 7. In part (e) of FIG. 7, squares each represent one component of a complex symbol (cell). Consecutive (adjacent) D complex symbols (cells) are referred to as a constellation block throughout this document.

Accordingly, in the constellation block, 2×B×D codeword bits are encoded. In the case where M = B and the above rotation topology is used, in each constellation block, 2×D consecutive bits of each M QBs of each bit-interleaver section are encoded.

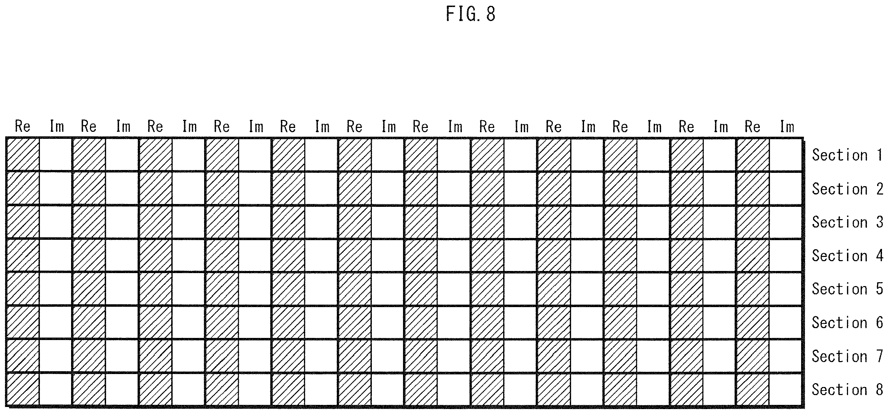

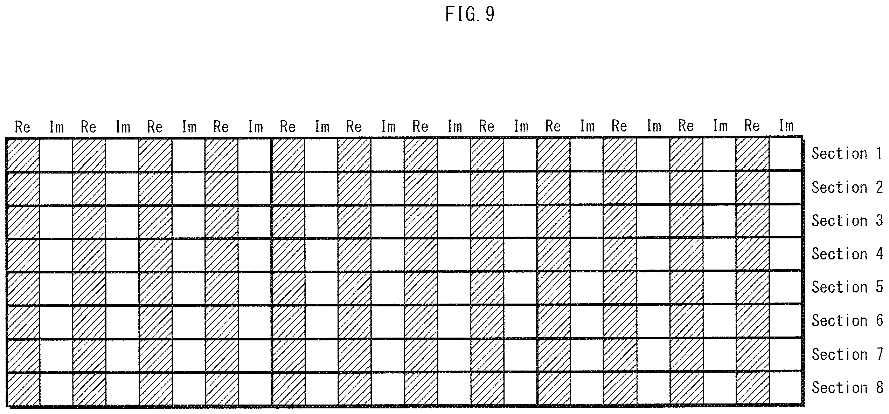

FIG. 8 and FIG. 9 show respective examples of mapping an output from the bit interleaver 120 to a non-rotated constellation and a (four-dimensional rotated) constellation block. Note that the cyclic factor Q is 24, and the number of sections is eight. In FIG. 8, each pair of two squares surrounded by a thick line corresponds to one complex symbol (cell). Also in FIG. 9, each combination of eight squares surrounded by a thick line corresponds to one four-dimensional rotated constellation block. This constellation block has the configuration in part (e) of FIG. 7.

The above method of mapping LDPC blocks to constellation blocks employing a rotated constellation results in increased complexity of the configuration of the receiver. This is due to the fact that the number of bits, which are mapped from each QB of the bit-interleaver section corresponding to the constellation block to the constellation block, depends on the number of dimensions D of the rotated constellation. More specifically, since 2×B×D codeword bits are encoded in the constellation block, this number of bits is 2×D as described above. This fact alone is not necessarily a problem. However, if the same receiver needs to support various numbers of dimensions (for example 1, 2, 4, and 8), the implementation efficiency would suffer. This is particularly true for receivers that use iterative decoding.

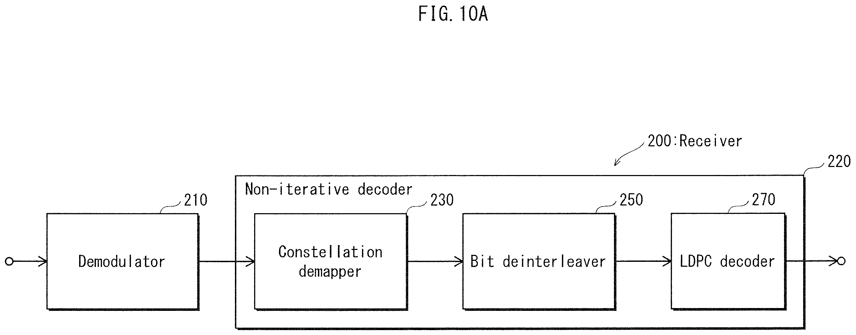

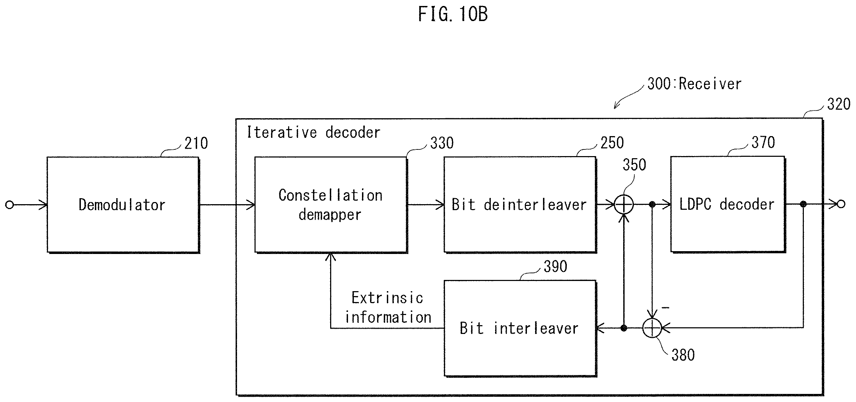

In order to better understand this reason, it is necessary to take a closer look at the structure of the LDPC decoder. FIG. 10A and FIG. 10B are generic block diagrams showing receivers employing non-iterative decoding and iterative decoding, respectively. In the description of FIG. 10A and FIG. 10B, the same reference signs are appended to the processing blocks that perform substantially the same processing in order to avoid duplicated description.

A receiver 200 in FIG. 10A includes a demodulator 210, a non-iterative decoder 220 (including a constellation demapper 230, a bit deinterleaver 250, and an LDPC decoder 270). It is found from FIG. 1 and FIG. 10A that the receiver 200 employing non-iterative decoding has the configuration corresponding to the configuration of the transmitter 100 in FIG. 1.

The demodulator 210 demodulates an input signal and outputs N×Q/(2×B) complex symbols (cells).

The constellation demapper 230 computes (soft) bits by applying a derotation and a QAM demapping to N×Q/(2×B) complex symbols. Note that the constellation demapper 230 performs the derotation and the QAM demapping for each D components corresponding to D transformed PAM symbols of a D-dimensional rotated constellation on the transmission side. The only point of the configuration of the receiver 200 that does not correspond to the configuration of the transmitter 100 is that the derotation and the QAM demapping are performed by a single block, namely, the constellation demapper 230. To perform these two operations jointly is a condition necessary for achieving the optimal decoding performance.

The bit deinterleaver 250 deinterleaves a plurality of (soft) bits. The deinterleaving is performed in accordance with a rule that is the inverse of a rule used in interleaving performed by the bit interleaver 120 included in the transmitter 100 in order to restore the order of the (soft) bits to the order before the interleaving.

The LDPC decoder 270 decodes the deinterleaved (soft) bits. Note that the decoding performed by the LDPC decoder 270 is based on the LDPC code used in the encoding performed by the LDPC encoder 110 included in the transmitter 100.

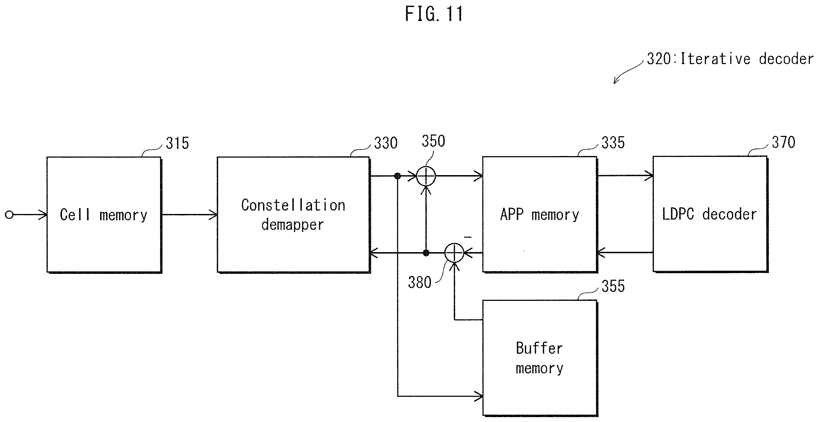

A receiver 300 in FIG. 10B includes a demodulator 210 and an iterative decoder 320 (including a constellation demapper 330, a bit deinterleaver 250, an adder 350, an LDPC decoder 370, a subtractor 380, and a bit interleaver 390). Note that processing performed by the processing blocks included in the iterative decoder 320 other than the bit deinterleaver 250 and the bit interleaver 390 is described later with reference to FIG. 11.

The bit interleaver 390 interleaves input extrinsic information. The interleaving of the extrinsic information is performed in accordance with the same permutation rule as the permutation rule used in the interleaving performed by the bit interleaver 120 included in the transmitter 100.

From the block diagram in FIG. 10B, it is found that iterative decoding is a technique that consists in performing constellation demapping and LDPC decoding iteratively. The two processes help each other by exchanging extrinsic information. The decoding performance is thereby improved significantly.

FIG. 11 is a detailed block diagram showing the iterative decoder 220B in FIG. 10B, in which the bit interleaver 390 and the bit deinterleaver 250 are omitted for the sake of clarity of the processing of iterative decoding. Particularly important in this configuration are the three memory blocks, namely, a cell memory 315, an APP memory 335, and a buffer memory 355. The cell memory 315 stores therein complex symbols (cells) generated by the demodulator 210. The cells stored in the cell memory 315 are available to the constellation demapper 330 throughout iterative decoding. The APP memory 335 stores therein a-posteriori probabilities (APPs) of bits, which are successively updated during decoding. The buffer memory 355 stores therein initial APPs that are generated by the constellation demapper 330 and are necessary for computing extrinsic a-posteriori probability information (extrinsic APP information).

Note that the constellation demapper 330 performs derotation and QAM demapping by a single block like the constellation demapper 230. The constellation demapper 330 performs the derotation and the QAM demapping for each D components corresponding to D transformed PAM symbols of a D-dimensional rotated constellation on the transmission side.

The operation of iterative decoding is briefly described with reference to the block diagram in FIG. 11.

In the first iteration, the constellation demapper 330 does not receive a-priori information from the LDPC decoder 370, and performs a blind (not aided by a-priori information) demapping of the complex symbols stored in the cell memory 315. This demapping includes extraction of soft bits from the cells stored in the cell memory 315. The soft bits obtained by the demapping (which are measures of APPs of bits, typically expressed as log-likelihood ratios) are directly written into the APP memory 335 and the buffer memory 355. In other words, in the first iteration, the adder 350 adds zero to the output from the constellation demapper 330, and outputs an addition result to the APP memory 335.

Once the soft bits of the LDPC codeword are written into the APP memory 335, the LDPC decoder 370 performs one or more LDPC decoding iterations using the soft bits written into the APP memory 335, and updates the storage content in the APP memory 335 using a result of the LDPC decoding iterations. Note that the decoding performed by the LDPC decoder 370 is based on the LDPC code used in the encoding performed by the LDPC encoder 110 included in the transmitter 100. This processing is known in this technical field.

After the one or more LDPC decoding iterations, outer iteration is performed by the constellation demapper 330. The outer iteration consists of the following steps (A) to (C).
(A) The subtractor 380 computes extrinsic information by subtracting the initial APPs stored in the buffer memory 355 from the updated APPs stored in the APP memory 335, and supplies the computed extrinsic information to the constellation demapper 330 as a-priori information.
(B) The constellation demapper 330 computes updated soft bits using the cells stored in the cell memory 315 and the a-priori information.
(C) The adder 350 adds the extrinsic information to the updated soft bits, and writes an addition result back to the APP memory 335.

The LDPC decoder 370 again performs one or more LDPC decoding iterations using the soft bits written into the APP memory 335, and updates the storage content in the APP memory 335 using a result of the LDPC decoding iterations.

The basic principles of iterative decoding are well known in this technical field, and therefore further description thereof is omitted.

However, what is important for understanding the present invention is the more detailed structure of a parallel iterative decoder for QC-LDPC codes.

FIG. 12 shows an example of the more detailed structure of a parallel iterative decoder for QC-LDPC codes with respect to non-rotated constellations (see FIG. 8). The configuration of the parallel iterative decoder whose configuration example is shown in FIG. 12 matches exactly the configuration of the iterative decoder 320 in FIG. 11, apart from the cell memory which is excluded for the sake of clarity. The configuration of the parallel iterative decoder in FIG. 12 has a high parallelism. The constellation demapper has several identical demappers. This enables greatly high throughputs (processing capacity or processing amount). The configuration with a high parallelism is made possible by the parallel structure inherent to the QC-LDPC codes and the configuration of the bit interleaver described above. The LDPC decoder includes cyclic shifters and check-node units (denoted by CN units in the figure). One of the cyclic shifters performs a cyclic shift of APP of bits of one QB supplied sequentially form the APP memory a predetermined number of times. The check-node unit performs decoding using the cyclically-shifted APP of the bits to update the APP of the bits. The other cyclic shifter performs a cyclic shift of the APP of the updated bits of each of QBs supplied sequentially form the check-node unit a predetermined number of times, such that the cyclic shift performed by the one cyclic shifter is cancelled. The LDPC decoder is greatly well known in this technical field, and therefore further description thereof is omitted.

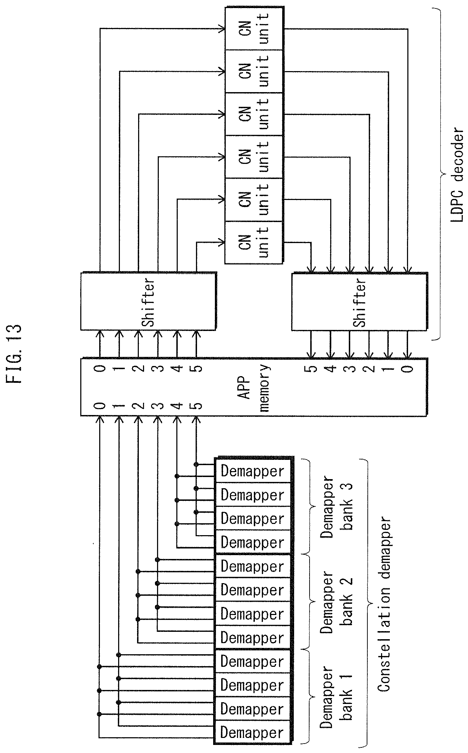

Furthermore, FIG. 13 shows a configuration example of a parallel non-iterative decoder for QC-LDPC codes. Unlike the parallel iterative decoder whose configuration example is shown in FIG. 12, the parallel non-iterative decoder includes no buffer memory, no adders, no subtractors, and demappers have no input of a-priori information. The parallel non-iterative decoder typically includes no cell memory either.

In order to achieve the throughput required by the demappers in FIG. 12 and FIG. 13, the APP memory is typically implemented using several memory banks in parallel. The designer can arbitrarily select any divisor of Q as the number of memory banks. In this document, the number of memory banks is denoted by P, and is a measure of the degree of parallelism. Thus, the number of memory banks is one of the most important design parameters.

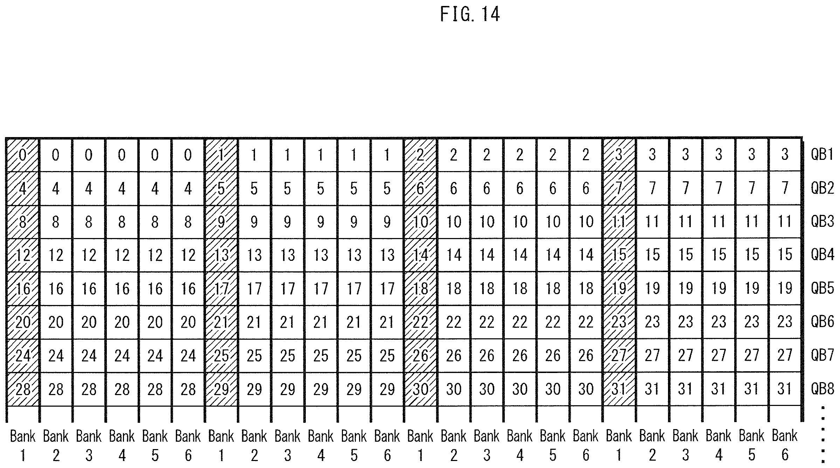

FIG. 14 shows a storage example of (soft) bits of an LDPC block in memory banks of the APP memory, for Q = 24 and P = 6. In FIG. 14, squares each represent one (soft) bit of the LDPC block, and a number in the square indicates an address of a bit in a corresponding memory bank. For clarity, hatched squares each indicate a bit in a first memory bank.

From the example in FIG. 14, it is easily found that Q/P bits of Q bits of each QB (Q/P = 24/6 = 4 bits in the example in FIG. 14) are each stored in a memory bank. It is also worth noting that the number of QBs per LDPC block determines the size of the memory banks but not the number of memory banks. Accordingly, exactly the same physical structure can be reused for a plurality of LDPC block sizes with the same Q.

A novel aspect of this implementation is that a similar bank memory structure is also used for the cell memory 315 in FIG. 11. Although not shown in FIG. 12, the cell memory 315 is an essential part of the iterative decoding.

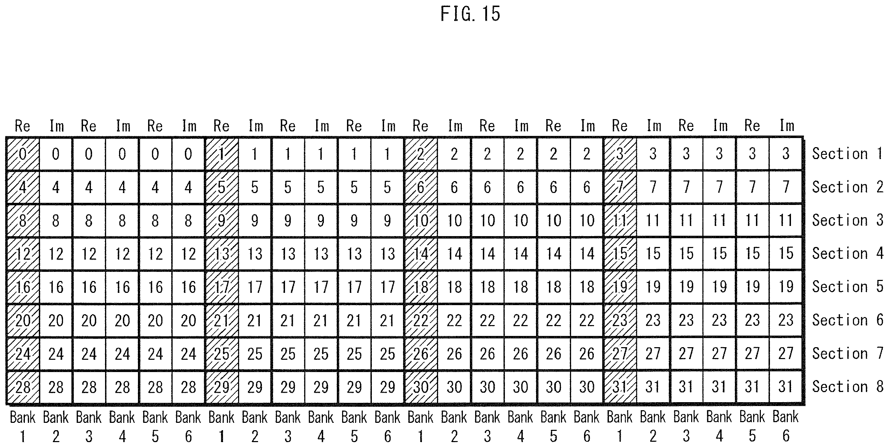

In the case where mapping in FIG. 8 is used, a memory layout of the cell memory 315 is as shown in IFG. 15. Thus, real components and imaginary components of the complex symbols (cells) are stored in odd banks and even banks, respectively. In FIG. 15, each pair of two squares surrounded by a thick line corresponds to a pair of a real component and an imaginary component of the same cell.

A plurality of demappers, which constitute the constellation demapper, are provided between the memory banks of the cell memory and the memory banks of the APP memory. According to an aspect of the present invention, the demappers are also divided into demapper banks. The number of demapper banks is equal to half the number of memory banks. The reason is that each demapper needs to access both a real component and an imaginary component of a complex cell, which are stored in different memory banks. The demapper banks each include one or more demappers. Preferably, the number of demappers in the demapper bank is selected such that the total number of demappers is a divisor or a multiple of Q. Thus, for the scenario (Q = 24) shown in FIG. 15, the number of demappers per demapper bank is 1, 2, 4, or any multiple of 4, such that the total number of demappers is a divisor of Q (1, 2, 3, 4, 6, 8, 12, or 24) or a multiple of Q (24, 48, ... or any multiple of 24). This number of demappers per demapper bank is a design parameter, and directly determines the maximum throughput achieved by iterative decoding.

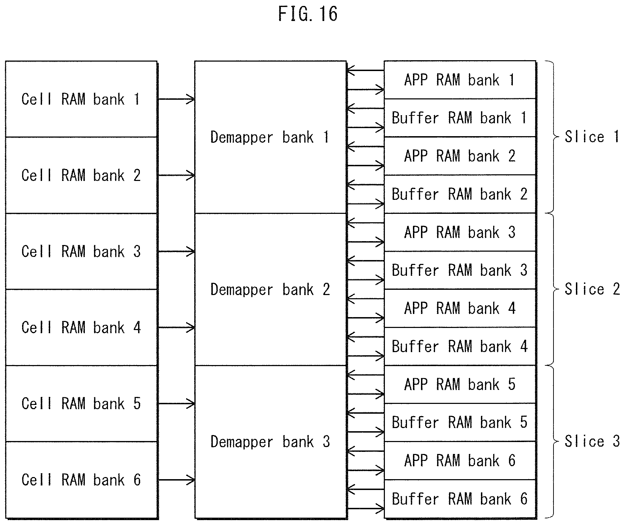

It is important to understand how efficiently the schematic diagram in FIG. 12 is for implementation in a real hardware structure. The hardware configuration shown as the example in FIG. 16 is greatly compact and regular owing to a high degree of parallelism and local data transfer. This dramatically reduces an amount of wire routing and thus a signal propagation delay and a hardware area, leading to a cheaper and faster implementation. Note that the adders and the subtractors in FIG. 12 are included in the demapper banks in FIG. 16 to improve clarity.

The primary reason why the wire routing is compact is that each demapper bank is connected to two adjacent banks of each of the three memories (the cell memory, the APP memory, and the buffer memory). These memory banks can easily be provided in the immediate vicinity of their associated demapper bank. The block layout of the LDPC decoder is thus naturally divided into P/2 (6/2 = 3 in the example in FIG. 16) identical slices, which contributes to an efficient hardware implementation.

Since the above implementation is greatly efficient, it is highly preferable to be able to decode rotated constellations using exactly the same configuration. The present inventor realized that in the case where the solution by the above art (see FIG. 9) is used, rotated constellations cannot be decoded using exactly the same configuration. Since each constellation block encodes 2×D adjacent bits of each QB, each demapper needs to be connected to 2×D memory banks. This significantly complicates the wire routing since a different wiring configuration is necessary for each value of D.

Moreover, the freedom of the designer in selecting the number of memory banks (and thus the parallelism of the LDPC decoder) is constrained by the fact that the number of memory banks needs to be 2×D.

It is therefore highly preferable that, in each LDPC decoder which performs non-iterative decoding and iterative decoding, each demapper bank is connected to only two memory banks regardless of the value of D. This can be achieved by the present invention.

According to the main aspect of the present invention for achieving this, mapping of bits of an LDPC block (bits output from the bit interleaver) to a constellation block is performed such that two D-dimensional vectors, which constitutes the constellation block, are generated from the same group of QBs and each encode only one bit of each of QBs belonging to the same group of QBs.

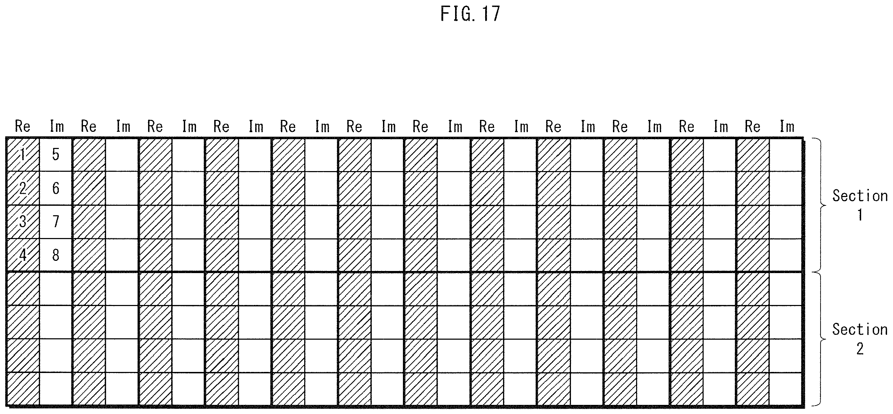

A specific example of this is shown in FIG. 17 for Q = 24 and D = 4. In FIG. 17, squares each represent a PAM symbol, and 2×D = 2×4 PAM symbols surrounded by a thick line constitute a constellation block. Four PAM symbols in the constellation block which are hatched constitute one of four-dimensional rotated constellations of a (four-dimensional rotated) constellation block, and four PAM symbols in the constellation block which are not hatched constitute the other four-dimensional rotated constellation. The difference from the art in FIG. 9 is easily understandable.

Specifically, this mapping layout can be achieved by selecting the parameter M (the number of QBs per bit-interleaver section) so as to be equal to B×D instead of the above B. Therefore, the number of bit-interleaver sections decreases from N/B to N/(B×D) (for example, from eight to two in the examples in FIG. 9 and FIG. 17).

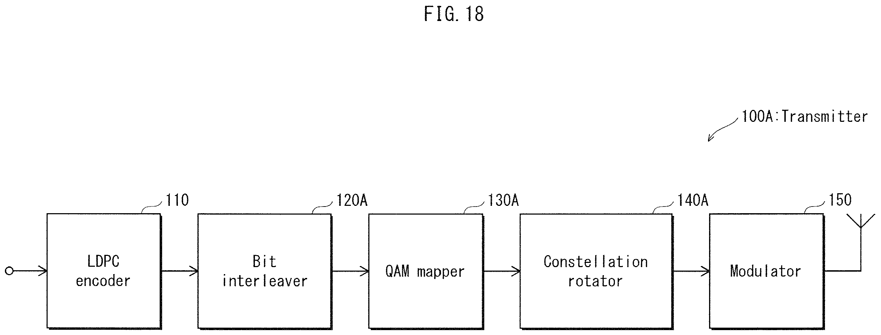

The following describes an example of a transmitter 100A relating to the present embodiment that performs the above mapping according to the main aspect of the present invention, with reference to FIG. 18.

The value of B may satisfy for example B = 1, 2, 3, 4, and the value of D may satisfy for example D = 2, 4, 8. However, the value of B and the value of D are not limited to these.

The transmitter 100A includes an LDPC encoder 110, a bit interleaver 120A, a QAM mapper 130A, a constellation rotator 140A, and a modulator 150. Note that the description of the transmitter 100 in FIG. 1 is applicable to the processing performed by the LDPC encoder 110 and the modulator 150, and therefore description thereof is omitted.

(Step 1) The bit interleaver 120A divides an LDPC block consisting of N QBs into N/M = N/(B×D) sections consisting of M = B×D QBs. The bit interleaver 120A interleaves Q×(B×D) bits using section permutation for each of the N/(B×D) sections separately such that Q bits of each of B×D QBs are mapped to Q groups of bits one bit by one bit (section interleaving). This section interleaving is realized by for example performing processing equivalent to writing Q×M = Q×(B×D) bits row by row into a section permutation matrix with Q columns and M rows = Q columns and (B×D) rows in the order of input and reading out the written Q×(B×D) bits column by column from the matrix. Note that B×D bits of each column of the matrix are each mapped from one bit of each of the B×D QBs belonging to the corresponding section. Also, B×D bits of each column constitute D PAM symbols.

(Step 2) The QAM mapper 130A maps each group of B consecutive bits output from the bit interleaver 120A to a PAM symbol.

(Step 3) For each group of 2×D adjacent PAM symbols, the constellation rotator 140A computes a first D-dimensional rotated vector and a second D-dimensional rotated vector, by multiplying a first D-dimensional vector having D adjacent PAM symbols as elements by an orthogonal matrix and by multiplying a second D-dimensional vector having D adjacent PAM symbols as elements by the orthogonal matrix, respectively (applies a first rotation and a second rotation). The multiplication is performed using the orthogonal matrix exemplified in the constellation rotator 140 in FIG. 1. In other words, the constellation rotator 140A computes the first D-dimensional rotated vector and the second D-dimensional rotated vector, by multiplying the first D-dimensional vector having D PAM symbols consisting of all bits of (2×j=1) column of a section permutation matrix as elements by an orthogonal matrix and by multiplying a second D-dimensional vector having D PAM symbols consisting of all bits of 2×j column of the section permutation matrix as elements by the orthogonal matrix, respectively (applies the first rotation and the second rotation). The multiplication is performed using the orthogonal matrix exemplified in the constellation rotator 140 in FIG. 1. The first D-dimensional vector and the second D-dimensional vector constitute one constellation block.

(Step 4) The constellation rotator 140A maps D transformed PAM symbols of the first D-dimensional rotated vector to D real or imaginary components of D adjacent complex symbols (cells) or D real or imaginary components of D unadjacent complex symbols, and maps D transformed PAM symbols of the second D-dimensional rotated vector to D remaining real or imaginary components of the D cells, and outputs mapping results.

Preferably, the D transformed PAM symbols of the first D-dimensional rotated vector and the D transformed PAM symbols of the second D-dimensional rotated vector are mapped to the D real components and the D imaginary components of the D adjacent cells, respectively. Alternatively, the D transformed PAM symbols of the first D-dimensional rotated vector and the D transformed PAM symbols of the second D-dimensional rotated vector are mapped to the D imaginary components and the D real components of the D adjacent cells, respectively.

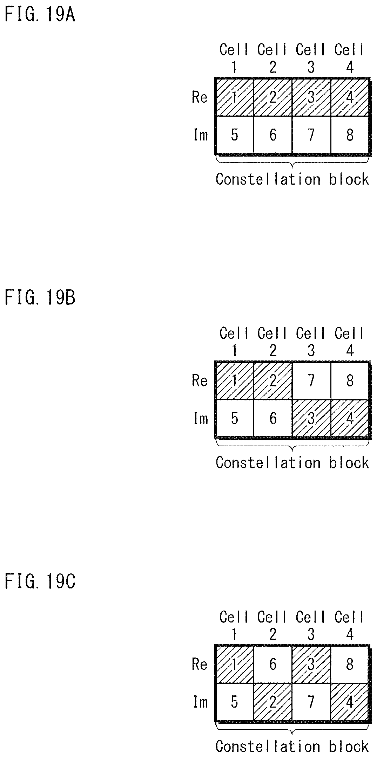

As an example of this, FIG. 19A shows mapping in the case of D = 4. In FIG. 19A, and FIG. 19B and FIG. 19C which are described later, squares each represent a transformed PAM symbol. Numbers I to 4 in the squares correspond to the transformed PAM symbols of the first D-dimensional rotated vector, and numbers 5 to 8 in the squares correspond to the transformed PAM symbols of the second D-dimensional rotated vector. The transformed PAM symbol indicated by the square in FIG. 19A, and FIG. 19B and FIG. 19C described later having the same number as the transformed PAM symbol indicated by the square in FIG. 17 correspond to each other.

Another example of mapping is shown in each of FIG. 19B and FIG. 19C.

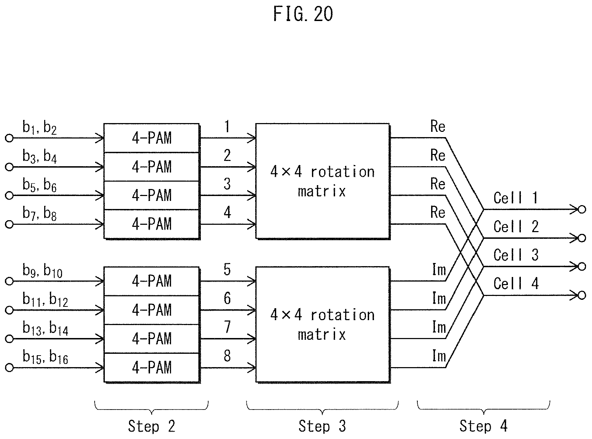

The processing from (Step 2) to (Step 4) is further shown in FIG. 20, where B = 2 and D = 4, and mapping of 2×D transformed PAM symbols to D adjacent complex symbols (cells) is performed as shown in FIG. 19A.

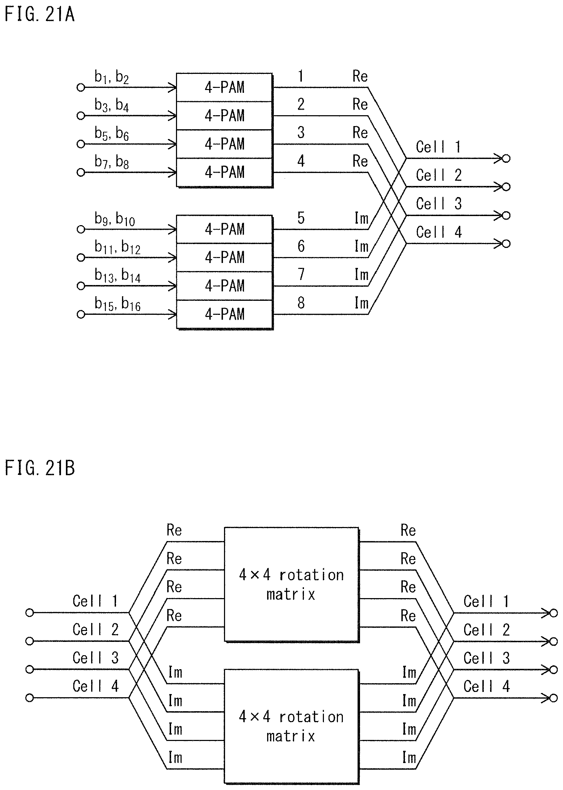

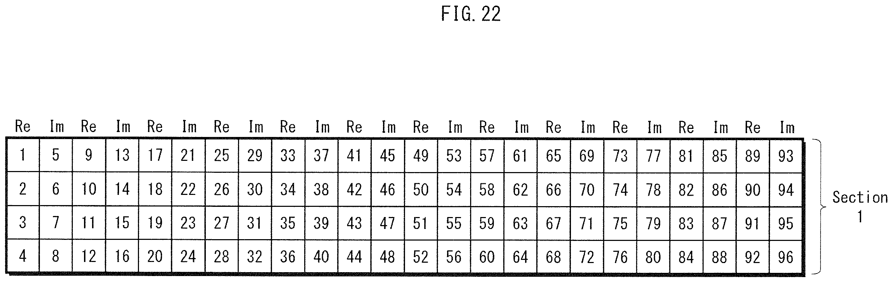

The details of (Step 2) and (Step 4) in FIG. 20 is shown in FIG. 21A, and the details of (Step 3) and (Step 4) in FIG. 20 is shown in FIG. 21B. Furthermore, FIG. 22 shows results of mapping PAM symbols generated in FIG. 21A to a non-rotated constellation block, where D = 4 and Q = 24. In FIG. 22, squares each represent a PAM symbol, and a number in the square indicates an index of the PAM symbol.

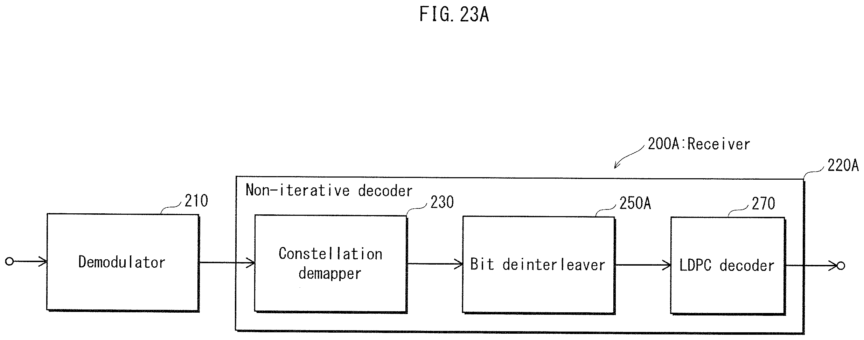

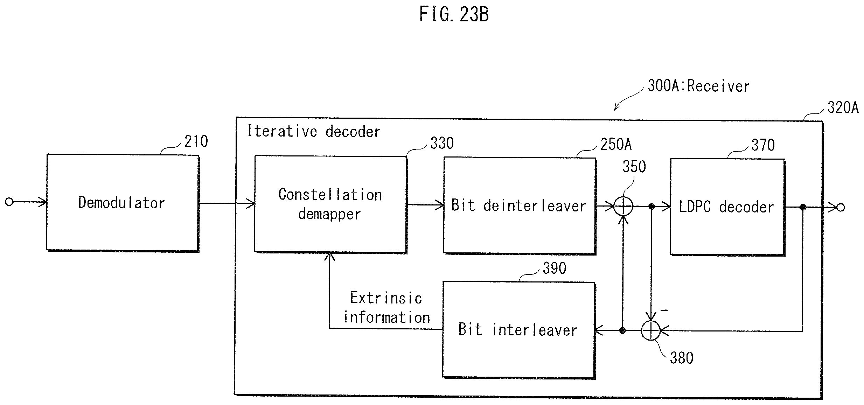

The following describes receivers 200A and 300A relating to the present embodiment, which correspond to the transmitter 100A in FIG. 18, with reference to FIG. 23A and FIG. 23, respectively. In the description of FIG. 23A and FIG. 23, the same reference signs are appended to the processing blocks that perform substantially the same processing as that in FIG. 10A and FIG. 10B in order to avoid duplicated description.

The receiver 200A is a receiver that performs non-iterative decoding, and includes a demodulator 210 and a non-iterative decoder 220A (a constellation demapper 230, a bit deinterleaver 250A, and an LDPC decoder 270).

The receiver 300A is a receiver that performs iterative decoding, and includes a demodulator 210 and an iterative decoder 320A (a constellation demapper 330, a bit deinterleaver 250A, an adder 350, an LDPC decoder 370, a subtractor 380, and a bit interleaver 390).

Note that the constellation demappers 230 and 330 each perform, by a single block, processing that reflects the QAM mapping performed by the QAM mapper 130A and the rotation performed by the constellation rotator 140A (derotation and QAM demapping) (see Steps 2 to 4 in FIG. 20).

The bit deinterleaver 250A included in each of the receivers 200A and 300A divides N×Q (soft) bits into N/M = N/(D×B) sections. Then, the bit deinterleaver 250A deinterleaves Q×M = Q×(D×B) (soft) bits for each of the N/(B×D) sections separately (section deinterleaving). In order to restore the order of the (soft) bits to the order before the section interleaving performed by the bit interleaver 120A included in the transmitter 100A, the section deinterleaving is performed in accordance with a permutation rule that is the inverse of the permutation rule used in the section interleaving. This section deinterleaving is realized by for example performing processing equivalent to writing Q×M = Q×(D×B) soft bits column by column into a section permutation matrix with Q columns and M rows = Q columns and D×B rows in the order of input and reading out the written Q×(D×B) soft bits row by row from the matrix.

The bit interleaver 390 included in the receiver 300A divides N×Q extrinsic information pieces into N/M = N/(D×B) sections. Then, the bit interleaver 390 interleaves Q×M = Q×(D×B) extrinsic information pieces for each of the N/(B×D) sections separately. This interleaving is performed in accordance with the same permutation rule as the permutation rule used in the section interleaving performed by the bit interleaver 120A included in the transmitter 100A. The interleaving of the extrinsic information of each of the sections is realized by for example performing processing equivalent to writing Q×M = Q×(D×B) extrinsic information pieces row by row into a section permutation matrix with Q columns and M rows = Q columns and D×B rows in the order of input and reading out the written Q×(D×B) extrinsic information pieces column by column from the matrix.

Note that the non-iterative decoder 220A and the iterative decoder 320A can use the detailed structure or the parallel structure described with reference to FIG. 11 to FIG. 16.

Also, the bit interleaver 120A included in the transmitter 100A may additionally have a function of performing QB permutation and/or intra-QB permutation prior to the section interleaving (see FIG. 6). In this case, the bit deinterleaver 250A should additionally have a function of performing interleaving subsequent to the section deinterleaving in accordance with a rule that is the inverse of the rule used in the intra-QB permutation and/or the QB permutation, and the bit interleaver 390 should additionally have a function of performing interleaving prior to the section interleaving in accordance with a rule that is the same as the rule used in the QB permutation and/or the intra-QB permutation.

### <Examination by the Inventor and Embodiment (2)>

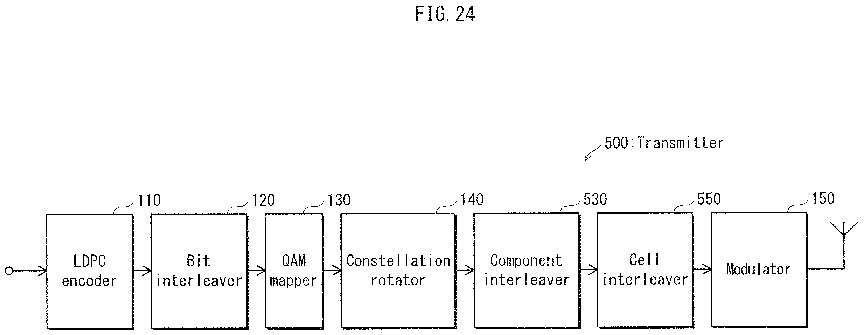

FIG. 24 is another block diagram showing a generic transmitter that employs rotated constellations in conjunction with QC-LDPC codes. In the description of FIG. 24, the same reference signs are appended to the processing blocks that perform substantially the same processing as that in FIG. 1 in order to avoid duplicated description. The block diagram in FIG. 24 shows only the blocks relevant to the present invention.

The transmitter 500 is equivalent to the transmitter100 in FIG. 1 in which a component interleaver 530 and a cell interleaver 550 are added.

The component interleaver 530 interleaves D transformed PAM symbols of each D-dimensional rotated vector (D components of each rotated constellation) such that the D transformed PAM symbols are spread over the entire FEC block. Generally, a block interleaver is used as the component interleaver 530.

The cell interleaver 550 interleaves a plurality of cells output from the component interleaver 530 using a pseudo-random bit sequence (PRBS).

The cells of each FEC block are further spread in time and frequency by a time interleaver and a frequency interleaver, respectively. The time interleaver and the frequency interleaver are provided between the cell interleaver 550 and the modulator 150, but are omitted for the sake of clarity of the figure.

A block interleaver which is used as the component interleaver 530 is designed irrespective of the quasi-cyclic structure of LDPC codes. For this reason, the component interleaver 530, which is the block interleaver, cannot be easily parallelized based on the quasi-cyclic structure of LDPC codes. Since the component interleaver 530 is not suitable for parallelism, this prevents an efficient implementation particularly for receivers that employ iterative decoding.

It is therefore another aim of the present invention to disclose a component interleaver that is inherently parallelizable and can realize a highly efficient hardware implementation. Moreover, the disclosed component interleaver has a configuration similar to the configuration of the bit interleaver.

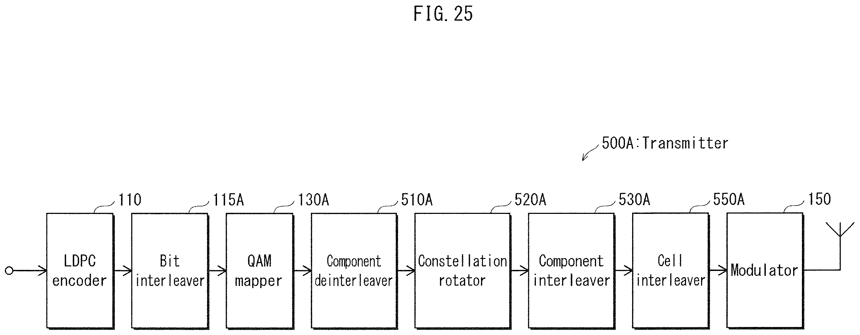

The following describes a transmitter 500A relating to the present embodiment including a component interleaver that is parallelizable, with reference to FIG. 25. In the description of FIG. 25, the same reference signs are appended to the processing blocks that perform substantially the same processing as that in FIG. 1 and FIG. 24 in order to avoid duplicated description.

The transmitter 500A includes an LDPC encoder 110, a bit interleaver 115A, a QAM mapper 130A, a component deinterleaver 510A, a constellation rotator 520A, a component interleaver 530A, a cell interleaver 550A, and a modulator 150.

The bit interleaver 115A divides an LDPC block consisting of N QBs into N/M sections consisting of M QBs, where M = B. The bit interleaver 115A interleaves Q×M bits using section permutation for each of the N/M sections separately such that Q bits of each of M QBs are mapped to Q groups of bits one bit by one bit (section interleaving). This section interleaving is realized by for example performing processing equivalent to writing the Q×M bits row by row into a section permutation matrix with Q columns and M rows in the order of input and reading out the written Q×M bits column by column from the matrix.

The component deinterleaver 510A divides N×Q/B PAM symbols which are output from the QAM mapper 130A into N/(B×D) sections. Then, the component deinterleaver 510A deinterleaves Q×D PAM symbols (components) for each of the N/(B×D) sections separately (component deinterleaving). The component deinterleaving is performed in accordance with a permutation rule that is the inverse of a permutation rule used in component interleaving performed by the component interleaver 530A, which is described later. Processing performed by the component deinterleaver 510A is described in detail later.

For each section output from the component deinterleaver 510A, the constellation rotator 520A computes a D-dimensional rotated vector having D transformed PAM symbols as elements by multiplying each D-dimensional vector having D PAM symbols which are consecutively output from the component deinterleaver 510A as elements by an orthogonal matrix. The multiplication is performed using the orthogonal matrix exemplified in the constellation rotator 140 in FIG. 1.

Owing to the functions of the bit interleaver 115A and the component deinterleaver 510A, each constellation block encodes only two bits of each of a predetermined number of QBs, and these two bits are mapped one bit by one bit to the same dimension of two D-dimensional vectors constituting a constellation block obtained by encoding the two bits.

The component interleaver 530A interleaves Q×D transformed PAM symbols for each of the N/(B×D) sections separately (component interleaving). The sections correspond to the sections which are deinterleaved by the component deinterleaver 510A.

The component interleaving in each section is realized by for example performing processing equivalent to writing Q×D transformed PAM symbols (components) column by column into a matrix with Q columns and D rows in the order of input, applying an appropriate cyclic shift (shift value of between 0 and Q-1) to each row, and reading out the Q×D cyclically-shifted transformed PAM symbols row by row from the matrix. As a result, the D transformed PAM symbols of each D-dimensional rotated vector are spread as evenly as possible over the section.

The component deinterleaving in each corresponding section is realized by for example performing processing equivalent to writing Q×D PAM symbols into a matrix with Q columns and D rows row by row in the order of input, applying a cyclic shift, which is exactly the inverse of the cyclic shift applied to each row by the component interleaver 530A, to the row, and reading out the Q×D cyclically-shifted PAM symbols column by column from the matrix.

Moreover, the cyclic shift is applied in accordance with the cell granularity. That is, the shift values are preferably even, i.e., a multiple of 2.

Owing to the processing performed by the bit interleaver 115A and the component deinterleaver 510A, and also owing to the processing performed by the bit interleaver 115A and a component deinterleaver 510B which is described later, mapping of bits of an LDPC block (bits output from the bit interleaver) to a constellation block is performed such that D-dimensional vectors, which constitute the constellation block, are generated from the same group of QBs and each encode only one bit of each of QBs belonging to the same group of QBs.

For the non-TFS case, in component interleaving for each section, a cyclic shift is applied to each row of the matrix, where a shift value is incremented by Q/D from a cyclic shift value of a cyclic shift applied to an immediately previous row.

Description is given on processing for one section performed by the component deinterleaver 510A and the component interleaver 530A relating to this example.

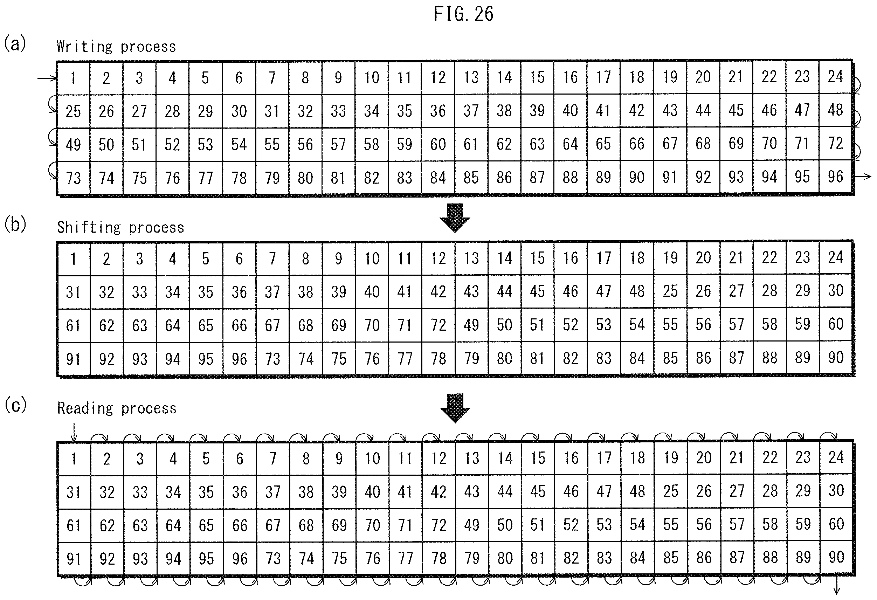

First, description is given on an example of component deinterleaving performed by the component deinterleaver 510A, where Q = 24 and D = 4, with reference to parts (a) to (c) of FIG. 26. In parts (a) to (c) of FIG. 26, squares each represent a PAM symbol, and a number in the square indicates the order of input of the PAM symbol.

As shown in part (a) of FIG. 26, the component deinterleaver 510A writes Q×D = 24×4 PAM symbols row by row into a matrix with Q columns and D rows = 24 columns and four rows in the order of input. Then, as shown in part (b) of FIG. 26, the component deinterleaver 510A applies a cyclic shift to elements of each row by -k×(Q/D) = -k×(24/4) = -k×6 PAM symbols, where k is an index of the row (beginning with zero). Furthermore, as shown in part (c) of FIG. 26, the component deinterleaver 510A reads out the cyclically-shifted Q×D = 24×4 PAM symbols column by column from this matrix. Note that the writing order and the reading order are each indicated by an arrow in parts (a) and (c) of FIG. 26, respectively.

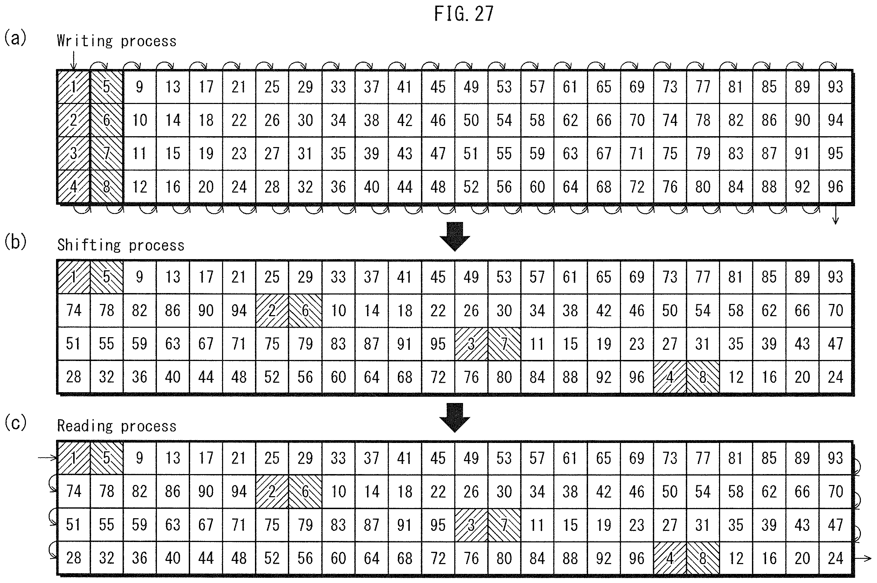

Next, description is given on an example of component interleaving performed by the component interleaver 530A, where Q = 24 and D = 4, with reference to parts (a) to (c) of FIG. 27. In parts (a) to (c) of FIG. 27, squares each represent a transformed PAM symbol (component), a number in the square indicates the order of input of the transformed PAM symbol, and two-type hatched squares represent respective elements of the first two four-dimensional rotated vectors.

As shown in part (a) of FIG. 27, the component interleaver 530A writes Q×D = 24×4 transformed PAM symbols column by column into a matrix with Q columns and D rows = 24 columns and four rows in the order of input. Then, as shown in part (b) of FIG. 27, the component interleaver 530A applies a cyclic shift to elements of each row by k×(Q/D) = k×(24/4) = k×6 transformed PAM symbols, where k is an index of the row (beginning with zero). Furthermore, as shown in part (c) of FIG. 27, the component interleaver 530A reads out the cyclically-shifted Q×D = 24×4 transformed PAM symbols row by row from this matrix. Note that the writing order and the reading order are each indicated by an arrow in parts (a) and (c) of FIG. 27, respectively.

Implementation of the component interleaving using cyclic shifts, which is disclosed in the present invention, has the advantage of a significantly reduced hardware complexity, particularly in the case of receivers that employ iterative decoding.

The component interleaver 530A sequentially maps each pair of two consecutive transformed PAM symbols, which are read from the matrix, to a complex symbol. As a result, D×Q/2 complex cells per section are obtained.

The cell interleaver 550A additionally interleaves N×Q/(2×B) cells of all the sections (cell interleaving). This cell interleaving is realized by for example performing processing equivalent to writing N×Q/(2×B) cells row by row into a matrix with Q/2 columns and N/B rows in the order of input and reading out the written N×Q/(2×B) cells column by column from this matrix.

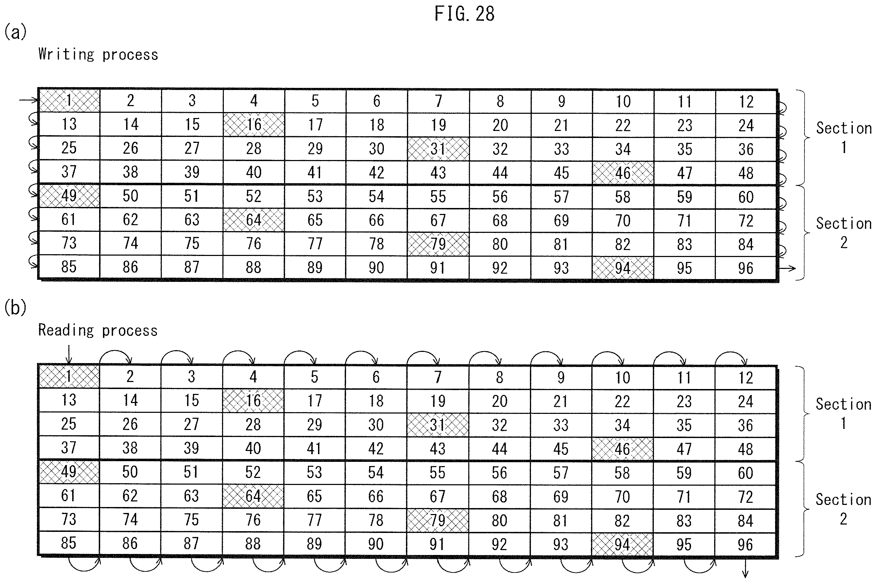

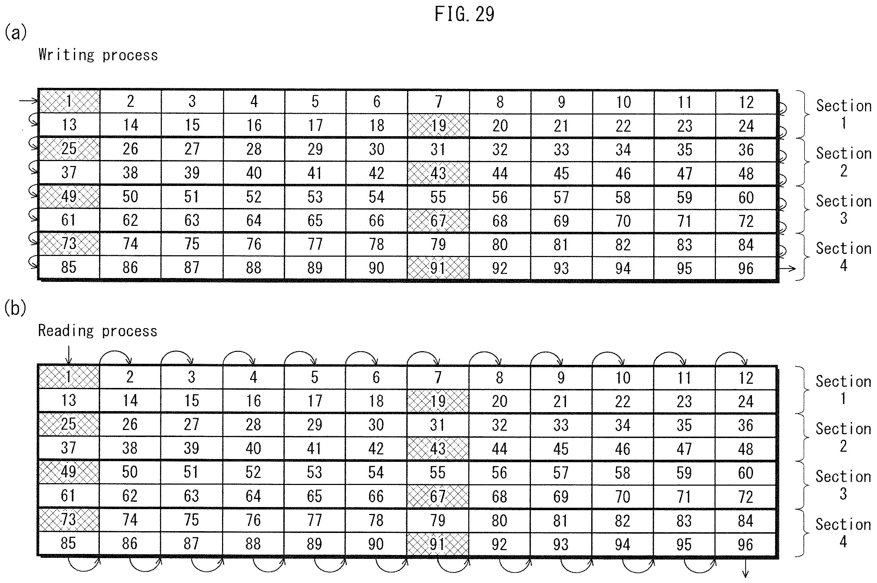

Here, description is given on an example of the cell interleaving with reference to parts (a) and (b) of FIG. 28 and parts (a) and (b) of FIG. 29. Note that parts (a) and (b) of FIG. 28 relate to Q = 24, D = 4, and N/(B×D) = 2 sections per LDPC block, and parts (a) and (b) of FIG. 29 relate to Q = 24, D = 2, and N/(B×D) = 4 sections per LDPC block. Note that the writing order and the reading order are each indicated by an arrow in parts (a) and (b) of FIG. 28 and parts (a) and (b) of FIG. 29, respectively. Also, a number in each rectangle indicates the order of input of the cell. Hatched rectangles in each section represent D complex symbols (cells) that carry 2×D components of the first D-dimensional rotated constellation. It is clearly found that the cell interleaver 550A does not depend on the parameter D.

The cell interleaver 550A writes 96 cells row by row into a matrix with 12 columns and eight rows in the order of input as shown in respective parts (a) of FIG. 28 and FIG. 29, and reads out the written 96 cells column by column from this matrix as shown in respective parts (b) of FIG. 28 and FIG. 29.

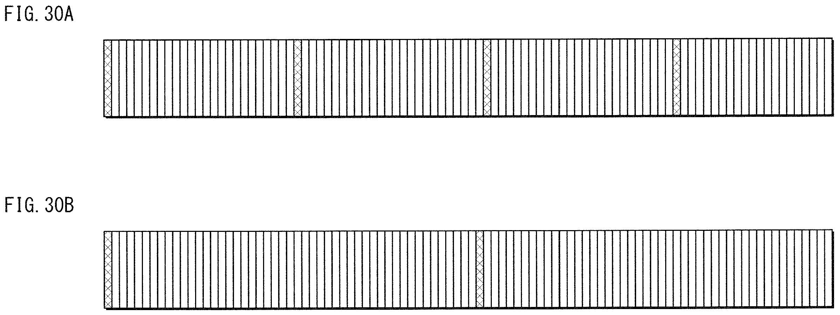

Examples of output from the cell interleaver 550A are shown in FIG. 30A and FIG. 30B, where FIG. 30A shows processing results of parts (a) and (b) of FIG. 28 and FIG. 30B shows processing results of parts (a) and (b) of FIG. 29. In FIG. 30A and FIG. 30B, D cells of the first constellation block are hatched. From FIG. 30A and FIG. 30B, it is found that the D cells of the first constellation block are spread greatly evenly over the entire LDPC block.

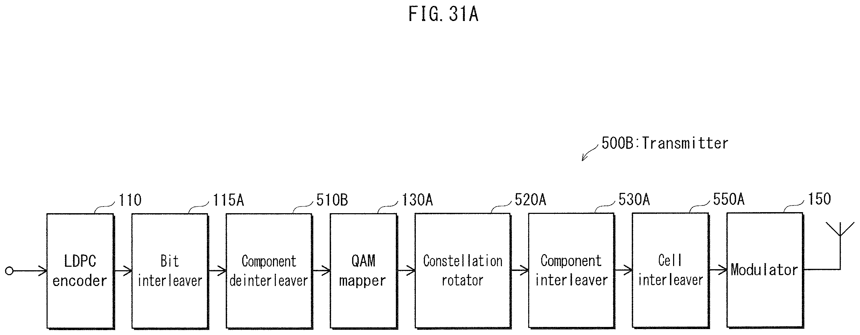

The following describes another transmitter 500B relating to the present embodiment with reference to FIG. 31A. In the description of FIG. 31A, the same reference signs are appended to the processing blocks that perform substantially the same processing as that in FIG. 1, FIG. 24, and FIG. 25 in order to avoid duplicated description.

While the transmitter 500A in FIG. 25 includes the component deinterleaver 510A after the QAM mapper 130A, the transmitter 500B in FIG. 31A includes the component deinterleaver 510B before the QAM mapper 130A. This is the difference therebetween.

The component deinterleaver 510B groups output bits into groups each consisting of B bits (bits of one PAM symbol) in the order of output from the bit interleaver 115A, and deinterleaves each group of B bits as one PAM symbol using the same permutation used by the component deinterleaver 510A.

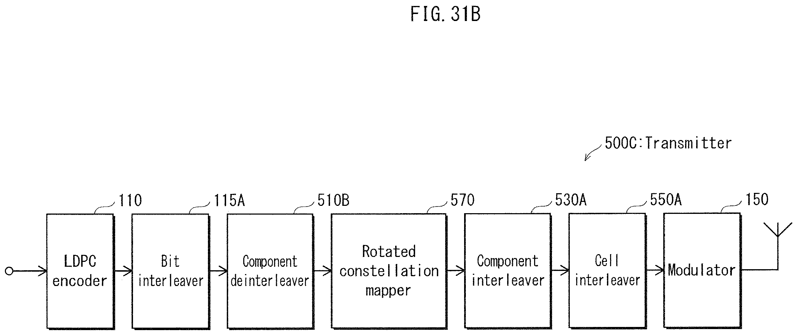

The following describes another transmitter 500C relating to the present embodiment with reference to FIG. 31B. In the description of FIG. 31B, the same reference signs are appended to the processing blocks that perform substantially the same processing as that in FIG. 1, FIG. 24, FIG. 25, and FIG. 31A in order to avoid duplicated description.

The transmitter 500C in FIG. 31B performs mapping and rotation, which are performed respectively by the QAM mapper 130A and the constellation rotator 520A included in the transmitter 500B in FIG. 31A, by a single block, namely, a rotated constellation mapper 570. In this case, 2×B×D bits are directly mapped to a rotated constellation block.

The layout in FIG. 31B allows a more efficient implementation.

Note that the bit interleaver 115A included in each of the transmitters 500A, 500B, and 500C may additionally have a function of performing QB permutation and/or intra-QB permutation prior to the section interleaving (see FIG. 6).

Referring to FIG. 31A and FIG. 31B, the component deinterleaver 510B applies a component deinterleaving to bits. In the case where the bit interleaver 115A performs intra-QB permutation based on cyclic shifts, the component deinterleaver 510B and the bit interleaver 115A have the same configuration based on the cyclic shifts. Accordingly, the component deinterleaver 510B can be incorporated into the bit interleaver 115A.

More specifically, a shift value of a cyclic shift applied to each row by the component deinterleaver 510B is added to a shift value of a cyclic shift in an intra-QB permutation that is to be applied to B QBs to be mapped to the row. Then, the bit interleaver 115B performs processing in which M = B is replaced with M = B×D.

As described above, the cyclic shifts in the intra-QB permutation themselves are incorporated into the definition of the LDPC code. In other words, the cyclic shifts performed by the component deinterleaver 510B can be incorporated into the definition of the QC-LDPC code together with the cyclic shifts in the intra-QB permutation performed by the bit interleaver 115A.

Therefore, the component deinterleaver included in the transmitter and the corresponding component interleaver included in the receiver are unnecessary in a hardware implementation.

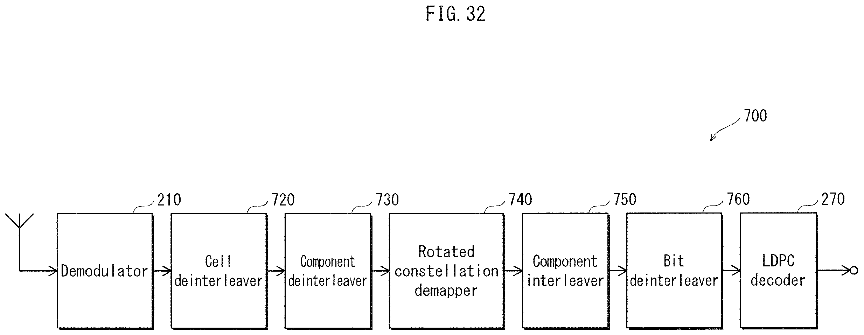

The following describes a receiver 700 relating to the present embodiment, which corresponds to the transmitter 500C in FIG. 31B, with reference to FIG. 32. The receiver 700 in FIG. 32 mirrors the functions of the transmitter 500C in FIG. 31B, and also corresponds to the transmitter 500A in FIG. 25 and the transmitter 500B in FIG. 31A. In the description of FIG. 32, the same reference signs are appended to the processing blocks that perform substantially the same processing as that in FIG. 10A and FIG. 10B in order to avoid duplicated description.

The receiver 700 includes a demodulator 210, a cell deinterleaver 720, a component deinterleaver 730, a rotated constellation demapper 740, a component interleaver 750, a bit deinterleaver 760, and an LDPC decoder 270.

In order to restore the order to the order before the permutation performed by the cell interleaver 550A included in the transmitter 500C, the cell deinterleaver 720 deinterleaves N×Q/(2×B) cells generated by the modulator 210 (cell deinterleaving). This cell deinterleaving is performed in accordance with a permutation rule that is the inverse of a permutation rule used in the cell interleaving. This cell deinterleaving is realized for example by performing processing equivalent to writing N×Q/(2×B) cells of one FEC block column by column into a matrix with Q/2 columns and N/B rows in the order of input and reading out the written N×Q/(2×B) cells row by row from this matrix.

In order to restore the order to the order before the permutation performed by the component interleaver 530A included in the transmitter 500C, the component deinterleaver 730 extracts N×Q/B components from N×Q/(2×B) cells which are output from the cell deinterleaver 720, divides the extracted N×Q/B components into N/(B×D) sections, and deinterleaves Q×D components for each of the N/(B×D) sections separately (component deinterleaving). This component deinterleaving is performed in accordance with a permutation rule that is the inverse of a permutation rule used in the component interleaving performed by the component interleaver 530A. The component deinterleaving in each section is realized by for example performing processing equivalent to writing Q×D components row by row into a matrix with Q columns and D rows in the order of input, applying a cyclic shift, which is exactly the inverse of the cyclic shift applied to each row by the component interleaver 530A, to the row, and reading out the cyclically-shifted Q×D components column by column from this matrix.

The rotated constellation demapper 740 sequentially demaps cells each consisting of a pair of two consecutive components which are input from the component deinterleaver 730 to extract (soft) bits, and outputs the extracted (soft) bits to the component interleaver 750. Note that the rotated constellation demapper 740 performs constellation derotation and QAM demapping by a single block. The rotated constellation demapper 740 performs the derotation and the QAM demapping for D components corresponding to D transformed PAM symbols of a D-dimensional rotated constellation on the transmission side. Performing these two operations jointly improves the decoding performance. This aspect is well known in this technical field.

In order to restore the order to the order before the permutation performed by the component deinterleaver 510B included in the transmitter 500C, the component interleaver 750 divides N×Q (soft) bits which are output from the rotated constellation demapper 740 into N/(B×D) sections, and interleaves Q×D groups of (soft) bits, each consisting of B (soft) bits, for each of the N/(B×D) sections separately (component interleaving). This component interleaving is performed in accordance with a permutation rule that is the inverse of a permutation rule used in the component deinterleaving performed by the component deinterleaver 510B. The component interleaving for each section is realized by for example performing processing equivalent to writing Q×D groups of (soft) bits column by column into a matrix with Q columns and D rows in the order of input, applying a cyclic shift, which is exactly the inverse of the cyclic shift applied to each row by the component deinterleaver 510B, to the row, and reading out the cyclically-shifted Q×D groups of (soft) bits row by row from this matrix.

The bit deinterleaver 760A divides N×Q (soft) bits into N/M sections, where M = B. Then, the bit deinterleaver 760 deinterleaves Q×M (soft) bits for each of the N/M sections separately (section deinterleaving). In order to restore the order to the order before the section interleaving performed by the bit interleaver 115A included in the transmitter 500C, the section deinterleaving is performed in accordance with a permutation rule that is the inverse of the permutation rule used in the section interleaving. This section deinterleaving is realized by for example performing processing equivalent to writing Q×M soft bits column by column into a section permutation matrix with Q columns and M rows in the order of input and reading out the written Q×M soft bits row by row from the matrix.

Note that in the case where the bit interleaver 115A included in each of the transmitters 500A, 500B, and 500C additionally has a function of performing QB permutation and/or intra-QB permutation prior to the section interleaving, the bit deinterleaver 760 should additionally have a function of performing interleaving subsequent to the section deinterleaving in accordance with a rule that is the inverse of the rule used in the intra-QB permutation and/or the QB permutation.

Regarding the transmitters 500B and 500C, the description has been given that the component deinterleaver 510B can be incorporated into the bit interleaver 115A. Like this, cyclic shifts performed by the component interleaver 750 can be incorporated into cyclic shifts relevant to intra-QB permutation performed by the bit deinterleaver 760. Also, the cyclic shifts performed by the component interleaver 750 can be incorporated into the definition of the QC-LDPC code together with the cyclic shifts relevant to intra-QB permutation performed by the bit interleaver 760. Therefore, the component interleaver 750 is unnecessary in a hardware implementation. Then, the bit interleaver 760B performs processing in which M = B is replaced with M = B×D.

This is particularly advantageous for receivers that employ iterative decoding.

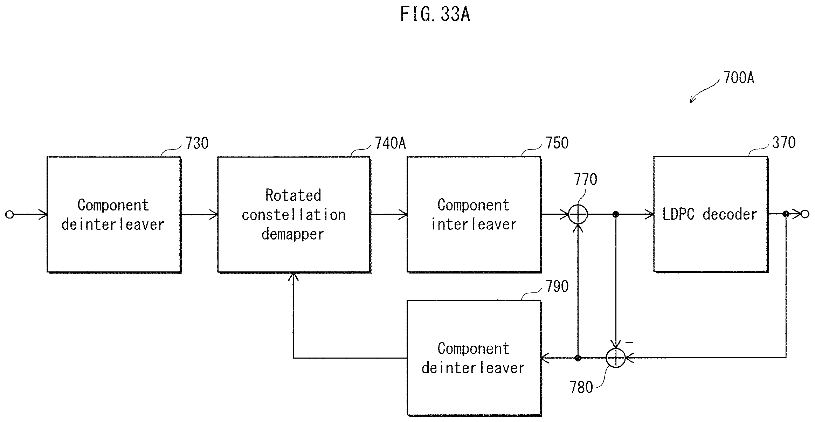

The following describes a receiver 700A that employs iterative decoding with reference to FIG. 33A. Note that FIG. 33A shows only processing blocks provided after the cell deinterleaver 720 in FIG. 32. In the description of FIG. 33A, the same reference signs are appended to the processing blocks that perform substantially the same processing as that in FIG. 10A, FIG. 10B, and FIG. 32 in order to avoid duplicated description. Note that a bit interleaver and a bit deinterleaver corresponding to the bit interleaver 115A included in each of the transmitters 500B and 500C are not included because of being unnecessary for hardware.

The receiver 700A includes a component deinterleaver 730, a rotated constellation demapper 740A, a component interleaver 750, an adder 770, an LDPC decoder 370, a subtractor 780, and a component deinterleaver 790.

The component deinterleaver 790 divides N×Q extrinsic information pieces output from the subtractor 780 into N/(B×D) sections, and deinterleaves Q×D groups of extrinsic information pieces, each consisting of B extrinsic information pieces, for each of the N/(B×D) sections separately (component deinterleaving). This component deinterleaving is performed in accordance with the same permutation rule as the permutation rule used in the component deinterleaving performed by the component deinterleaver 510B included in each of the transmitters 500B and 500C. The component deinterleaving in each section is realized by for example performing processing equivalent to writing the Q×D groups of extrinsic information pieces row by row into a matrix with Q columns and D rows in the order of input, applying a cyclic shift, which is exactly the same as the cyclic shift applied to each row by the component deinterleaver 510B, to the row, and reading out the cyclically-shifted Q×D groups of extrinsic information pieces column by column from this matrix.

Note that the processing performed by the rotated constellation demapper 740A, the adder 770, the LDPC decoder 370, and the subtractor 780 is substantially the same as the processing performed by the constellation demapper 330, the adder 350, the LDPC decoder 370, and the subtractor 380, which is described in detail with reference to FIG. 11.

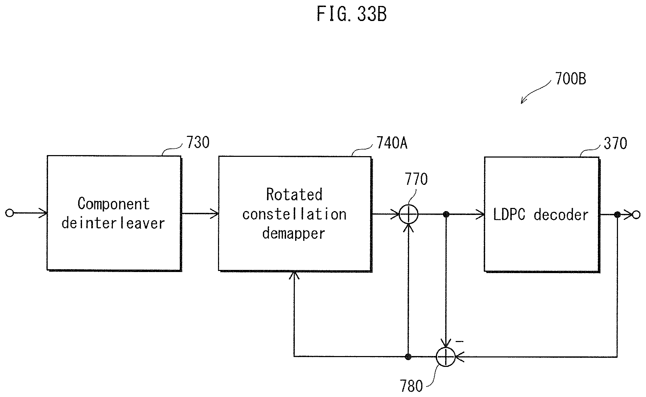

Since the component interleaver 750 and the component deinterleaver 790 are part of an iterative decoding loop, implementation of the iterative decoder can be greatly simplified if the component interleaver 750 and the component deinterleaver 790 are executed using cyclic shifts. The cyclic shifts, which are performed by the component interleaver 750 and the component deinterleaver 790, can be incorporated together with the cyclic shifts of the bit interleaver into the definition of the LDPC code used by the LDPC decoder 370. Thus, the receiver 700B is equivalent in configuration to the receiver 700A in which the component interleaver 750 and the component deinterleaver 790, which are provided between the rotated constellation demapper 740A and the LDPC decoder 370, are excluded as shown in FIG. 33B.

This enables the rotated constellation demapper 740A and the LDPC decoder 370 to be coupled more tightly. As a result, the rotated constellation demapper 740A and the LDPC decoder 370 can exchange data with no latency. Therefore, the receiver 700B in FIG. 33B is clearly superior to the receiver 700A in FIG. 33A.

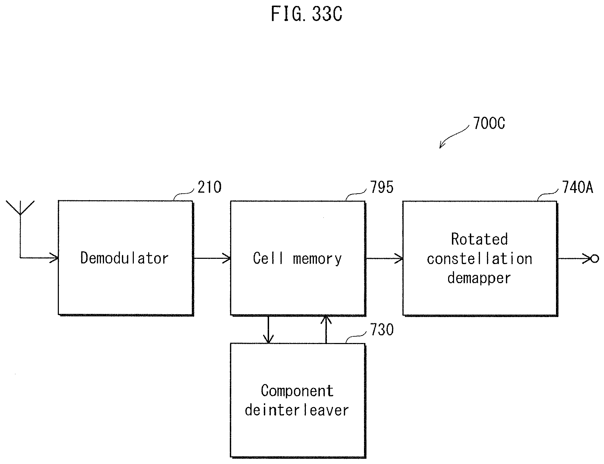

In addition to the optimization of the iterative decoding loop, an efficient implementation of the component interleaver 730 that is outside the loop can be realized. FIG. 33C shows how this efficient implementation is realized.

For each row in parts (a) and (b) of FIG. 28 and parts (a) and (b) of FIG. 29, Q/2 cells of the row are read from a cell memory 795, cyclically shifted, and written back to the same places, i.e. at the same addresses by the component deinterleaver 730. No additional memory is therefore required, and the latency is greatly low as the cyclic shift is performed in units of rows instead of over the entire FEC block.

### <Supplement (1)>

The present invention is not limited to the above embodiments, but rather may be embodied in a variety of ways, such as those described below, for achieving the aim of the present invention or other aims related or associated thereto. For example, the following modifications are possible.
(1) The above embodiments may relate to the implementation using hardware and software. The above embodiments may be implemented or executed using computing devices (processors). The computing devices or processors may for example be main processors/general purpose processors, digital signal processors (DSP), application specific integrated circuits (ASIC), field programmable gate arrays (FPGA) or other programmable logic devices, etc. The above embodiments may also be executed or embodied by a combination of these devices.
   Further, the above embodiments may also be implemented by means of software modules, which are executed by a processor or directly in hardware. Also a combination of software modules and a hardware implementation may be possible. The software modules may be stored on any kind of computer-readable storage media, for example RAM, EPROM, EEPROM, flash memory, registers, hard disks, CD-ROM, DVD, etc.
(3) In the above Embodiment 2, as shown in FIG. 25, FIG. 31A, and FIG. 31B, the cell interleaver 550A is provided after the component interleaver 530A. The layout of the cell interleaver 550A is not limited to this. Alternatively, the cell interleaver 550A may be provided after the QAM mapper 130A in FIG. 25 and FIG. 31A, and may be provided after the bit interleaver 115A in FIG. 31B. In this case, the cell deinterleaver 720 should be provided after the component interleaver 750 in FIG. 32.

### <Supplement (2)>

The following summarizes the transmission method, the transmitter, the reception method, and the receiver relating to the embodiments and so on, as well as the effects thereof.

The first transmission method for transmitting, in a communication system employing D-dimensional rotated constellations, a codeword generated based on a quasi-cyclic low-density parity-check coding scheme including a repeat-accumulate quasi-cyclic low-density parity-check coding scheme, real-valued symbols each being obtained by encoding B bits, the codeword consisting of N quasi-cyclic blocks, the quasi-cyclic blocks each consisting of Q bits, the transmission method comprising the steps of:
dividing the codeword into N/(B×D) sections each consisting of M = B×D quasi-cyclic blocks, applying a bit permutation to M×Q = (B×D)×Q bits of each of the sections, and grouping the permuted (B×D)×Q bits of each of the sections into Q groups of bits each consisting of M = (B×D) bits, the bit permutation being adapted such that the Q bits of each of the quasi-cyclic blocks are mapped to Q different groups of bits;
mapping B bits of each of the groups of bits to a real-valued symbol;
transforming a D-dimensional vector having D real-valued symbols generated from the groups of bits as elements into a D-dimensional rotated constellation having D transformed real-valued symbols as elements by multiplying the D-dimensional vector by an orthogonal matrix with D columns and D rows, the orthogonal matrix being a matrix for spreading values of elements in each dimension of the D-dimensional vector over at least two dimensions, D-dimensional vectors that are generated from the same B×D quasi-cyclic blocks constituting a constellation block; and
mapping N×Q/B transformed real-valued symbols to N×Q/(2×B) complex symbols such that 2×D transformed real-valued symbols of each of the rotated constellation blocks are mapped to D complex symbols and the D transformed real-valued symbols of each of the D-dimensional rotated constellations are mapped to D different complex symbols.

The first transmitter for transmitting, in a communication system employing D-dimensional rotated constellations, a codeword generated based on a quasi-cyclic low-density parity-check coding scheme including a repeat-accumulate quasi-cyclic low-density parity-check coding scheme, real-valued symbols each being obtained by encoding B bits, the codeword consisting of N quasi-cyclic blocks, the quasi-cyclic blocks each consisting of Q bits, the transmitter comprising:
a bit interleaver dividing the codeword into N/(B×D) sections each consisting of M = B×D quasi-cyclic blocks, applying a bit permutation to M×Q = (B×D)×Q bits of each of the sections, and grouping the permuted (B×D)×Q bits of each of the sections into Q groups of bits each consisting of M = (B×D) bits, the bit permutation being adapted such that the Q bits of each of the quasi-cyclic blocks are mapped to Q different groups of bits;
a constellation mapper mapping B bits of each of the groups of bits to a real-valued symbol;
a constellation rotator transforming a D-dimensional vector having D real-valued symbols generated from the groups of bits as elements into a D-dimensional rotated constellation having D transformed real-valued symbols as elements by multiplying the D-dimensional vector by an orthogonal matrix with D columns and D rows, the orthogonal matrix being a matrix for spreading values of elements in each dimension of the D-dimensional vector over at least two dimensions, D-dimensional vectors that are generated from the same B×D quasi-cyclic blocks constituting a constellation block, and mapping N×Q/B transformed real-valued symbols to N×Q/(2×B) complex symbols such that 2×D transformed real-valued symbols of each of the rotated constellation blocks are mapped to D complex symbols and the D transformed real-valued symbols of each of the D-dimensional rotated constellations are mapped to D different complex symbols.

According to the first transmission method or the first transmitter, it is possible to avoid complexity in the configuration of a receiver due to that the receiver uses a plurality of numbers of dimensions D.

In the second transmission method of the first transmission method,
the bit permutation is equivalent to writing the (B×D)×Q bits of each of the sections row by row into a section permutation matrix with Q columns and B×D rows and reading out the written (B×D)×Q bits column by column from the section permutation matrix.

According to the second transmission method, it is possible to efficiently apply a bit permutation to a codeword.

In the third transmission method of the first transmission method,
the step of mapping the N×Q/B transformed real-valued symbols to the N×Q/(2×B) complex symbols is performed such that the D transformed real-valued symbols of each of the D-dimensional rotated constellations are mapped to either D real components of D consecutive complex symbols or D imaginary components of D consecutive complex symbols.

In the fourth transmission method of the first transmission method,
the step of mapping the N×Q/B transformed real-valued symbols to the N×Q/(2×B) complex symbols is performed such that D transformed real-valued symbols of each of two D-dimensional rotated constellations are mapped to the same D consecutive complex symbols, the two D-dimensional rotated constellations being generated from consecutive groups of bits belonging to the same section.

The first reception method for receiving, in a communication system employing D-dimensional rotated constellations, a codeword generated based on a quasi-cyclic low-density parity-check coding scheme including a repeat-accumulate quasi-cyclic low-density parity-check coding scheme, real-valued symbols each being obtained by encoding B bits, the codeword consisting of N quasi-cyclic blocks, the quasi-cyclic blocks each consisting of Q bits, two D-dimensional vectors that are generated from the same B×D quasi-cyclic blocks constituting a constellation block, the D-dimensional vectors each being generated from one bit of each of M = B×D quasi-cyclic blocks, the reception method comprising the steps of:
demapping received N×Q/(2×B) complex symbols based on (N×Q)/(B×D) D-dimensional rotated constellations each having D transformed real-valued symbols as elements and being generated from D-dimensional vectors;
dividing N×Q bits obtained by the demapping into N/M = N/(B×D) sections each consisting of M = B×D quasi-cyclic blocks; and
applying an inverse bit permutation to M×Q = (B×D)×Q bits of each of the sections, the inverse bit permutation being the inverse of a bit permutation performed by a transmitter.

The first receiver for receiving, in a communication system employing D-dimensional rotated constellations, a codeword generated based on a quasi-cyclic low-density parity-check coding scheme including a repeat-accumulate quasi-cyclic low-density parity-check coding scheme, real-valued symbols each being obtained by encoding B bits, the codeword consisting of N quasi-cyclic blocks, the quasi-cyclic blocks each consisting of Q bits, two D-dimensional vectors that are generated from the same B×D quasi-cyclic blocks constituting a constellation block, the D-dimensional vectors each being generated from one bit of each of M = B×D quasi-cyclic blocks, the receiver comprising:
a constellation demapper demapping received N×Q/(2×B) complex symbols based on (N×Q)/(B×D) D-dimensional rotated constellations each having D transformed real-valued symbols as elements and being generated from D-dimensional vectors; and
a bit deinterleaver dividing N×Q bits obtained by the demapping into N/M = N/(B×D) sections each consisting of M = B×D quasi-cyclic blocks, and applying an inverse bit permutation to M×Q = (B×D)×Q bits of each of the sections, the inverse bit permutation being the inverse of a bit permutation performed by a transmitter.

According to the first reception method or the first receiver, it is possible to avoid complexity in the configuration of a receiver even in the case where a plurality of numbers of dimensions D are used.

In the second reception method of the first reception method,
the inverse bit permutation is equivalent to writing the (B×D)×Q bits of each of the sections column by column into a section permutation matrix with Q columns and B×D rows and reading out the written (B×D)×Q bits row by row from the section permutation matrix.

In the second receiver of the first receiver,
the inverse bit permutation is equivalent to writing the (B×D)×Q bits of each of the sections column by column into a section permutation matrix with Q columns and B×D rows and reading out the written (B×D)×Q bits row by row from the section permutation matrix.

According to the second reception method and the second receiver, it is possible to efficiently perform processing of restoring the order of bits obtained by demapping to the original order.

The third receiver of the first receiver, further comprising
a first memory storing therein N×Q bits output from the constellation demapper, the first memory being divided into P first memory banks in parallel, P being a divisor of Q, wherein
the constellation demapper includes a plurality of constellation demapper units, the constellation demapper units being divided into P/2 demapper banks, the demapper banks each being configured to access two adjacent of the first memory banks.

According to the third receiver, it is possible to provide a receiver having a simple configuration independent on the number of dimensions D used by the receiver.

The fourth receiver of the third receiver, further comprising
a second memory storing therein N×Q/(2×B) complex symbols, the second memory being divided into P second memory banks in parallel, wherein
the demapper banks are each further configured to access two adjacent of the second memory banks.

According to the fourth receiver, it is possible to provide a receiver having a simple configuration independent on the number of dimensions D used by the receiver.

The fifth transmission method for transmitting, in a communication system employing D-dimensional rotated constellations, a codeword generated based on a quasi-cyclic low-density parity-check coding scheme including a repeat-accumulate quasi-cyclic low-density parity-check coding scheme, real-valued symbols each being obtained by encoding B bits, the codeword consisting of N quasi-cyclic blocks, the quasi-cyclic blocks each consisting of Q bits, the transmission method comprising the steps of:
mapping B bits to a real-valued symbols;
transforming a D-dimensional vector having D real-valued symbols as elements into a D-dimensional rotated constellation having D transformed real-valued symbols as elements by multiplying the D-dimensional vector by an orthogonal matrix with D columns and D rows, two D-dimensional vectors that are generated from the same B×D quasi-cyclic blocks constituting a constellation block, the D-dimensional vectors each being generated from one bit of each of B×D quasi-cyclic blocks, the orthogonal matrix being a matrix for spreading values of elements in each dimension of the D-dimensional vector over at least two dimensions; and
dividing N×Q/B transformed real-valued symbols into N/(B×D) sections, and applying a first component permutation to Q×D transformed real-valued symbols of each of the sections, the first component permutation being equivalent to writing the Q×D transformed real-valued symbols column by column into a first component permutation matrix with Q columns and D rows, applying a cyclic shift to each of rows of the first component permutation matrix, and reading out the cyclically-shifted Q×D transformed real-valued symbols row by row from the first component permutation matrix.

The second transmitter for transmitting, in a communication system employing D-dimensional rotated constellations, a codeword generated based on a quasi-cyclic low-density parity-check coding scheme including a repeat-accumulate quasi-cyclic low-density parity-check coding scheme, real-valued symbols each being obtained by encoding B bits, the codeword consisting of N quasi-cyclic blocks, the quasi-cyclic blocks each consisting of Q bits, the transmitter comprising:
a constellation mapper mapping B bits to a real-valued symbols;
a constellation rotator transforming a D-dimensional vector having D real-valued symbols as elements into a D-dimensional rotated constellation having D transformed real-valued symbols as elements by multiplying the D-dimensional vector by an orthogonal matrix with D columns and D rows, two D-dimensional vectors that are generated from the same B×D quasi-cyclic blocks constituting a constellation block, the D-dimensional vectors each being generated from one bit of each of B×D quasi-cyclic blocks, the orthogonal matrix being a matrix for spreading values of elements in each dimension of the D-dimensional vector over at least two dimensions; and
a component interleaver dividing N×Q/B transformed real-valued symbols into N/(B×D) sections, and applying a first component permutation to Q×D transformed real-valued symbols of each of the sections, the first component permutation being equivalent to writing the Q×D transformed real-valued symbols column by column into a first component permutation matrix with Q columns and D rows, applying a cyclic shift to each of rows of the first component permutation matrix, and reading out the cyclically-shifted Q×D transformed real-valued symbols row by row from the first component permutation matrix.

According to the fifth transmission method or the second transmitter, the first constellation permutation is suitable for the quasi-cyclic structure of the quasi-cyclic low-density parity-check code used for encoding a codeword. As a result, it is possible to realize the first constellation permutation with a high parallelism and efficiency.

The sixth transmission method of the fifth transmission method, further comprising the step of:
mapping two consecutive of the transformed real-valued symbols, which have undergone the first component permutation, to a complex symbol, and applying a complex symbol permutation to N×Q/(2×B) complex symbols, the complex symbol permutation being equivalent to writing the N×Q/(2×B) complex symbols row by row into a complex symbol permutation matrix with Q/2 columns and N/B rows and reading out the written N×Q/(2×B) complex symbols column by column from the complex symbol permutation matrix.

According to the sixth transmission method, it is possible to spread D complex symbols transmitting D transformed PAM symbols of the same D-dimensional rotated constellation, comparatively evenly over a plurality of complex symbols generated from one codeword.

The seventh transmission method of the fifth transmission method, further comprising the step of:
dividing N×Q/B real-valued symbols obtained by mapping the B bits to the real-valued symbol into N/(B×D) sections, and applying a second component permutation to Q×D real-valued symbols of each of the sections, the second component permutation being equivalent to writing the Q×D real-valued symbols row by row into a second component permutation matrix with Q columns and D rows, applying an inverse cyclic shift to each of rows of the second component permutation matrix, and reading out the cyclically-shifted Q×D real-valued symbols column by column from the second component permutation matrix, the inverse cyclic shift being the inverse of the cyclic shift applied in the first component permutation.

According to the seventh transmission method, it is possible to avoid the first component permutation from reducing a result of spreading complex symbols obtained owing to the complex symbol permutation, by using the second component permutation.

In the eighth transmission method of the fifth transmission method,
the cyclic shift applied to k rows of the first component permutation matrix is k×Q/D, k being an index of the row beginning with zero.

In the ninth transmission method of the fifth transmission method,
the cyclic shift applied to k rows of the first component permutation matrix is an even.

The third reception method for receiving, in a communication system employing D-dimensional rotated constellations, a codeword generated based on a quasi-cyclic low-density parity-check coding scheme including a repeat-accumulate quasi-cyclic low-density parity-check coding scheme, real-valued symbols each being obtained by encoding B bits, the codeword consisting of N quasi-cyclic blocks, the quasi-cyclic blocks each consisting of Q bits, two D-dimensional vectors that are generated from the same B×D quasi-cyclic blocks constituting a constellation block, the D-dimensional vectors each being generated from one bit of each of M = B×D quasi-cyclic blocks, the reception method comprising the steps of:
dividing N×Q/B components based on N×Q/(2×B) complex symbols into N/(B×D) sections, and applying a component permutation to Q×D components of each of the sections, the component permutation being equivalent to writing the Q×D components row by row into a component permutation matrix with Q columns and D rows, applying an inverse cyclic shift to each of rows of the component permutation matrix, and reading out the cyclically-shifted Q×D components column by column from the component permutation matrix, the inverse cyclic shift being the inverse of a cyclic shift performed by a transmitter; and
demapping N×Q/(2×B) complex symbols that have undergone the component permutation, based on (N×Q)/(B×D) D-dimensional rotated constellations each having D transformed real-valued symbols as elements and being generated from D-dimensional vectors.

The fifth receiver for receiving, in a communication system employing D-dimensional rotated constellations, a codeword generated based on a quasi-cyclic low-density parity-check coding scheme including a repeat-accumulate quasi-cyclic low-density parity-check coding scheme, real-valued symbols each being obtained by encoding B bits, the codeword consisting of N quasi-cyclic blocks, the quasi-cyclic blocks each consisting of Q bits, two D-dimensional vectors that are generated from the same B×D quasi-cyclic blocks constituting a constellation block, the D-dimensional vectors each being generated from one bit of each of M = B×D quasi-cyclic blocks, the receiver comprising:
a component deinterleaver dividing N×Q/B components based on N×Q/(2×B) complex symbols into N/(B×D) sections, and applying a component permutation to Q×D components of each of the sections, the component permutation being equivalent to writing the Q×D components row by row into a component permutation matrix with Q columns and D rows, applying an inverse cyclic shift to each of rows of the component permutation matrix, and reading out the cyclically-shifted Q×D components column by column from the component permutation matrix, the inverse cyclic shift being the inverse of a cyclic shift performed by a transmitter; and
a rotated constellation demapper demapping N×Q/(2×B) complex symbols that have undergone the component permutation, based on (N×Q)/(B×D) D-dimensional rotated constellations each having D transformed real-valued symbols as elements and being generated from D-dimensional vectors.

According to the third reception method or the fifth receiver, it is possible to avoid complexity in the configuration of a receiver even in the case where a plurality of numbers of dimensions D are used, and the component permutation is suitable for the quasi-cyclic structure of the quasi-cyclic low-density parity-check code used for encoding a codeword. As a result, it is possible to realize the component permutation with a high parallelism and efficiency.

### [Industrial Applicability]

The present invention is utilizable for a transmission method and a reception method that are executed in a communication system that employs rotated constellations in conjunction with QC-LDPC codes.

### [Reference Signs List]

100A, 500A, 500B, 500C transmitter
110 LDPC encoder
115A, 120A bit interleaver
130A QAM mapper
140A constellation rotator
150 modulator
200A, 300A, 700, 700A, 700B receiver
210 demodulator
220A non-iterative decoder
230, 330 constellation demapper
250A bit deinterleaver
270, 370 LDPC decoder
320A iterative decoder
350, 770 adder
380, 780 subtractor
390 bit interleaver
510A, 510B component deinterleaver
520A constellation rotator
530A component interleaver
550A cell interleaver
570 rotated constellation mapper
720 cell deinterleaver
730 component deinterleaver
740, 740A rotated constellation demapper
750 component interleaver
760 bit deinterleaver
790 component deinterleaver

## Claims

1. A transmission method for transmitting, in a communication system employing D-dimensional rotated constellations, a codeword generated based on a quasi-cyclic low-density parity-check coding scheme including a repeat-accumulate quasi-cyclic low-density parity-check coding scheme, the codeword consisting of N quasi-cyclic blocks, the quasi-cyclic blocks each consisting of Q bits, and real-valued symbols each being obtained by mapping B bits, the transmission method comprising the steps of:
dividing the codeword into N/(B×D) sections, N/(B×D) being an integer number, each section consisting of M = B×D quasi-cyclic blocks, applying a bit permutation to M×Q = (B×D)×Q bits of each of the sections, and grouping the permuted (B×D)×Q bits of each of the sections into Q groups of bits each consisting of M bits, the bit permutation being adapted such that the Q bits of each of the quasi-cyclic blocks are mapped to Q different groups of bits;
mapping B bits of each of the groups of bits to a real-valued symbol;
transforming a D-dimensional vector having D real-valued symbols generated from the groups of bits as elements into a D-dimensional rotated constellation block having D transformed real-valued symbols as elements by multiplying the D-dimensional vector by an orthogonal matrix with D columns and D rows, the orthogonal matrix being a matrix for spreading values of elements in each dimension of the D-dimensional vector over at least two dimensions, constellation blocks each consisting of D-dimensional vectors that are generated from the same B×D quasi-cyclic blocks;
mapping N×Q/B transformed real-valued symbols to N×Q/(2×B) complex symbols such that 2×D transformed real-valued symbols for each of the constellation blocks are mapped to D complex symbols and the D transformed real-valued symbols of each of the D-dimensional rotated constellations are mapped to D different complex symbols; and
transmitting the N×Q/(2×B) complex symbols.

2. The transmission method according to claim 1, wherein
the bit permutation is equivalent to writing the (B×D)×Q bits of each of the sections row by row into a section permutation matrix with Q columns and B×D rows and reading out the written (B×D)×Q bits column by column from the section permutation matrix.

3. The transmission method according to claim 1, wherein
the step of mapping the N×Q/B transformed real-valued symbols to the N×Q/(2×B) complex symbols is performed such that the D transformed real-valued symbols of each of the D-dimensional rotated constellations are mapped to either D real components of D consecutive complex symbols or D imaginary components of D consecutive complex symbols.

4. The transmission method according to claim 1, wherein
the step of mapping the N×Q/B transformed real-valued symbols to the N×Q/(2×B) complex symbols is performed such that D transformed real-valued symbols of each of two D-dimensional rotated constellations are mapped to the same D consecutive complex symbols, the two D-dimensional rotated constellations being generated from consecutive groups of bits belonging to the same section.

5. A reception method for receiving, in a communication system employing D-dimensional rotated constellations, a codeword generated based on a quasi-cyclic low-density parity-check coding scheme including a repeat-accumulate quasi-cyclic low-density parity-check coding scheme, the codeword consisting of N quasi-cyclic blocks, the quasi-cyclic blocks each consisting of Q bits, two D-dimensional vectors that are generated from the same B×D quasi-cyclic blocks constituting a constellation block, the D-dimensional vectors each being generated from one bit of each of M = B×D quasi-cyclic blocks, and real-valued symbols each being obtained by mapping B bits, the reception method comprising the steps of:
demapping received N×Q/(2×B) complex symbols based on (N×Q)/(B×D) D-dimensional rotated constellations each having D transformed real-valued symbols as elements and being generated from D-dimensional vectors;
dividing N×Q bits obtained by the demapping into N/M = N/(B×D) sections, N/(B×D) being an integer number, each section consisting of M quasi-cyclic blocks; and
applying an inverse bit permutation to M×Q = (B×D)×Q bits of each of the sections, the inverse bit permutation being the Inverse of a bit permutation performed by a transmitter.

6. The reception method according to claim 5, wherein
the inverse bit permutation is equivalent to writing the (B×D)×Q bits of each of the sections column by column into a section permutation matrix with Q columns and B×D rows and reading out the written (B×D)×Q bits row by row from the section permutation matrix.

7. A transmitter for transmitting, in a communication system employing D-dimensional rotated constellations, a codeword generated based on a quasi-cyclic low-density parity-check coding scheme including a repeat-accumulate quasi-cyclic low-density parity-check coding scheme, the codeword consisting of N quasi-cyclic blocks, the quasi-cyclic blocks each consisting of Q bits, and real-valued symbols each being obtained by mapping B bits, the transmitter comprising:
a bit interleaver dividing the codeword into N/(B×D) sections, N/(B×D) being an integer number, each section consisting of M = B×D quasi-cyclic blocks, applying a bit permutation to M×Q = (B×D)×Q bits of each of the sections, and grouping the permuted (B×D)×Q bits of each of the sections into Q groups of bits each consisting of M bits, the bit permutation being adapted such that the Q bits of each of the quasi-cyclic blocks are mapped to Q different groups of bits;
a constellation mapper mapping B bits of each of the groups of bits to a real-valued symbol; and
a constellation rotator transforming a D-dimensional vector having D real-valued symbols generated from the groups of bits as elements into a D-dimensional rotated constellation block having D transformed real-valued symbols as elements by multiplying the D-dimensional vector by an orthogonal matrix with D columns and D rows, the orthogonal matrix being a matrix for spreading values of elements in each dimension of the D-dimensional vector over at least two dimensions, constellation blocks each consisting of D-dimensional vectors that are generated from the same B×D quasi-cyclic blocks, and mapping N×Q/B transformed real-valued symbols to N×Q/(2×B) complex symbols such that 2×D transformed real-valued symbols for each of the constellation blocks are mapped to D complex symbols and the D transformed real-vaiued symbols of each of the D-dimensional rotated constellations are mapped to D different complex symbols; and
a transmitter transmitting the N×Q/(2×B) complex symbols.

8. A receiver for receiving, in a communication system employing D-dimensional rotated constellations, a codeword generated based on a quasi-cyclic low-density parity-check coding scheme including a repeat-accumulate quasi-cyclic low-density parity-check coding scheme, the codeword consisting of N quasi-cyclic blocks, the quasi-cyclic blocks each consisting of Q bits, two D-dimensional vectors that are generated from the same B×D quasi-cyclic blocks constituting a constellation block, the D-dimensional vectors each being generated from one bit of each of M = B×D quasi-cyclic blocks, and real-valued symbols each being obtained by mapping B bits, the receiver comprising:
a constellation demapper demapping received N×Q/(2×B) complex symbols based on (N×Q)/(B×D) D-dimensional rotated constellations each having D transformed real-valued symbols as elements and being generated from D-dimensional vectors; and
a bit deinterleaver dividing N×Q bits obtained by the demapping into N/M = N/(B×D) sections, N/(B×D) being an integer number, each section consisting of M quasi-cyclic blocks, and applying an inverse bit permutation to M×Q = (B×D)×Q bits of each of the sections, the inverse bit permutation being the inverse of a bit permutation performed by a transmitter.

9. The receiver according to claim 8, wherein
the inverse bit permutation is equivalent to writing the (B×D)×Q bits of each of the sections column by column into a section permutation matrix with Q columns and B×D rows and reading out the written (B×D)×Q bits row by row from the section permutation matrix.

10. The receiver according to claim 8, further comprising
a first memory storing therein N×Q bits output from the constellation demapper, the first memory being divided into P first memory banks in parallel, P being a divisor of Q, wherein
the constellation demapper includes a plurality of constellation demapper units, the constellation demapper units being divided into P/2 demapper banks, the demapper banks each being configured to access two adjacent of the first memory banks.

11. The receiver according to claim 10, further comprising
a second memory storing therein N×Q/(2×B) complex symbols, the second memory being divided into P second memory banks in parallel, wherein
the demapper banks are each further configured to access two adjacent of the second memory banks.

12. A transmission method for transmitting, in a communication system employing D-dimensional rotated constellations, a codeword generated based on a quasi-cyclic low-density parity-check coding scheme including a repeat-accumulate quasi-cyclic low-density parity-check coding scheme, the codeword consisting of N quasi-cyclic blocks, the quasi-cyclic blocks each consisting of Q bits, and real-valued symbols each being obtained by mapping B bits, the transmission method comprising the steps of:
mapping B bits to a real-valued symbol;
transforming a D-dimensional vector having D real-valued symbols as elements into a D-dimensional rotated constellation having D transformed real-valued symbols as elements by multiplying the D-dimensional vector by an orthogonal matrix with D columns and D rows, two D-dimensional vectors that are generated from the same B×D quasi-cyclic blocks constituting a constellation block, the D-dimensional vectors each being generated from one bit of each of B×D quasi-cyclic blocks, the orthogonal matrix being a matrix for spreading values of elements in each dimension of the D-dimensional vector over at least two dimensions;
dividing N×Q/B transformed real-valued symbols into N/(B×D) sections, N/(B×D) being an integer number, such that the D transformed real-valued symbols of the D-dimensional rotated constellation block are included in the same section, and applying a first component permutation to Q×D transformed real-valued symbols of each of the sections, the first component permutation being equivalent to writing the Q×D transformed real-valued symbols column by column into a first component permutation matrix with Q columns and D rows, applying a cyclic shift to each of rows of the first component permutation matrix, and reading out the cyclically-shifted Q×D transformed real-valued symbols row by row from the first component permutation matrix; and
transmitting N×Q/(2×B) complex symbols each consisting of two transformed real-valued symbols.

13. The transmission method according to claim 12, further comprising the step of:
before transmitting the N×Q/(2×B) complex symbols,
mapping two consecutive of the transformed real-valued symbols, which have undergone the first component permutation, to a complex symbol, and applying a complex symbol permutation to the N×Q/(2×B) complex symbols, the complex symbol permutation being equivalent to writing the N×Q/(2×B) complex symbols row by row into a complex symbol permutation matrix with Q/2 columns and N/B rows and reading out the written N×Q/(2×B) complex symbols column by column from the complex symbol permutation matrix.

14. The transmission method according to claim 12, further comprising the step of:
dividing N×Q/B real-valued symbols obtained by mapping the B bits to the real-valued symbol into N/(B×D) sections, and applying a second component permutation to Q×D real-valued symbols of each of the sections, the second component permutation being equivalent to writing the Q×D real-valued symbols row by row into a second component permutation matrix with Q columns and D rows, applying an inverse cyclic shift to each of rows of the second component permutation matrix, and reading out the cyclically-shifted Q×D real-valued symbols column by column from the second component permutation matrix, the inverse cyclic shift being the inverse of the cyclic shift applied in the first component permutation.

15. The transmission method according to claim 12, wherein
the cyclic shift applied to k rows of the first component permutation matrix is k×Q/D, k being an index of the row beginning with zero.

16. The transmission method according to claim 12, wherein
the cyclic shift applied to k rows of the first component permutation matrix is an even integer number.

17. A reception method for receiving, in a communication system employing D-dimensional rotated constellations, a codeword generated based on a quasi-cyclic low-density parity-check coding scheme including a repeat-accumulate quasi-cyclic low-density parity-check coding scheme, the codeword consisting of N quasi-cyclic blocks, the quasi-cyclic blocks each consisting of Q bits, two D-dimensional vectors that are generated from the same B×D quasi-cyclic blocks constituting a constellation block, the D-dimensional vectors each being generated from one bit of each of M = B×D quasi-cyclic blocks, and real-valued symbols each being obtained by mapping B bits, the reception method comprising the steps of:
dividing N×Q/B components based on N×Q/(2×B) complex symbols into N/(B×D) sections, N/(B×D) being an integer number, such that D components that correspond to D transformed real-valued symbols of a D-dimensional rotated constellation block are included in the same section, and applying a component permutation to Q×D components of each of the sections, the component permutation being equivalent to writing the Q×D components row by row into a component permutation matrix with Q columns and D rows, applying an inverse cyclic shift to each of rows of the component permutation matrix, and reading out the cyclically-shifted Q×D components column by column from the component permutation matrix, the inverse cyclic shift being the inverse of a cyclic shift performed by a transmitter; and
demapping N×Q/(2×B) complex symbols that have undergone the component permutation, based on (N×Q)/(B×D) D-dimensional rotated constellations each having D transformed real-valued symbols as elements and being generated from D-dimensional vectors.

18. A transmitter for transmitting, in a communication system employing D-dimensional rotated constellations, a codeword generated based on a quasi-cyclic low-density parity-check coding scheme including a repeat-accumulate quasi-cyclic low-density parity-check coding scheme, the codeword consisting of N quasi-cyclic blocks, the quasi-cyclic blocks each consisting of Q bits, and real-valued symbols each being obtained by mapping B bits, the transmitter comprising:
a constellation mapper mapping B bits to a real-valued symbol;
a constellation rotator transforming a D-dimensional vector having D real-valued symbols as elements into a D-dimensional rotated constellation block having D transformed real-valued symbols as elements by multiplying the D-dimensional vector by an orthogonal matrix with D columns and D rows, two D-dimensional vectors that are generated from the same B×D quasi-cyclic blocks constituting a constellation block, the D-dimensional vectors each being generated from one bit of each of B×D quasi-cyclic blocks, the orthogonal matrix being a matrix for spreading values of elements in each dimension of the D-dimensional vector over at least two dimensions;
a component interleaver dividing N×Q/B transformed real-valued symbols into N/(B×D) sections, N/(B×D) being an integer number, such that the D transformed real-valued symbols of the D-dimensional rotated constellation are included in the same section, and applying a first component permutation to Q×D transformed real-valued symbols of each of the sections, the first component permutation being equivalent to writing the Q×D transformed real-valued symbols column by column into a first component permutation matrix with Q columns and D rows, applying a cyclic shift to each of rows of the first component permutation matrix, and reading out the cyclically-shifted Q×D transformed real-valued symbols row by row from the first component permutation matrix; and
a transmitter transmitting N×Q/(2×B) complex symbols each consisting of two transformed real-valued symbols.

19. A receiver for receiving, in a communication system employing D-dimensional rotated constellations, a codeword generated based on a quasi-cyclic low-density parity-check coding scheme including a repeat-accumulate quasi-cyclic low-density parity-check coding scheme, the codeword consisting of N quasi-cyclic blocks, the quasi-cyclic blocks each consisting of Q bits, two D-dimensional vectors that are generated from the same B×D quasi-cyclic blocks constituting a constellation block, the D-dimensional vectors each being generated from one bit of each of M = B×D quasi-cyclic blocks, and real-valued symbols each being obtained by mapping B bits, the receiver comprising:
a component deinterleaver dividing N×Q/B components based on N×Q/(2×B) complex symbols into N/(B×D) sections, N/(B×D) being an integer number, such that D components that correspond to D transformed real-valued symbols of a D-dimensional rotated constellation are included in the same section, and applying a component permutation to Q×D components of each of the sections, the component permutation being equivalent to writing the Q×D components row by row into a component permutation matrix with Q columns and D rows, applying an inverse cyclic shift to each of rows of the component permutation matrix, and reading out the cyclically-shifted Q×D components column by column from the component permutation matrix, the inverse cyclic shift being the inverse of a cyclic shift performed by a transmitter; and
a rotated constellation demapper demapping N×Q/(2×B) complex symbols that have undergone the component permutation, based on (N×Q)/(B×D) D-dimensional rotated constellations each having D transformed real-valued symbols as elements and being generated from D-dimensional vectors.

## Patentansprüche

1. Sendeverfahren zum Senden eines auf der Basis eines Quasi-Cyclic-Low-Density-Parity-Check-Codierschemas umfassend ein Repeat-Accumulate-Quasi-Cyclic-Low-Density-Parity-Check-Codierschema erzeugten Codeworts in einem D-dimensionale gedrehte Konstellationen verwendenden Kommunikationssystem, wobei das Codewort aus N quasizyklischen Blöcken, wobei die quasizyklischen Blöcke jeweils aus Q Bits bestehen, und jeweils durch Zuordnen von B Bits erhaltenen reellen Symbolen besteht, wobei das Sendeverfahren die Schritte umfasst zum:
Teilen des Codeworts in N/(BxD) Abschnitte, wobei N/(BxD) eine Ganzzahl ist, wobei jeder Abschnitt aus M = BxD quasizyklischen Blöcken besteht, Anwenden einer Bit-Permutation auf MxQ = (BxD)xQ Bits von jedem der Abschnitte und Gruppieren der permutierten (BxD)xQ Bits von jedem der Abschnitte zu Q Gruppen von Bits jeweils bestehend aus M Bits, wobei die Bit-Permutation so ausgebildet ist, dass die Q Bits von jedem der quasizyklischen Blöcke Q verschiedenen Gruppen von Bits zugeordnet werden;
Zuordnen von B Bits von jeder der Gruppen von Bits zu einem reellen Symbol;
Transformieren eines D-dimensionalen Vektors mit aus den Gruppen von Bits als Elemente erzeugten D reellen Symbolen in einen D-dimensionalen gedrehten Block mit gedrehter Konstellation mit D transformierten reellen Symbolen als Elemente durch Multiplizieren des D-dimensionalen Vektors durch eine orthogonale Matrix mit D Spalten und D Zeilen, wobei die orthogonale Matrix eine Matrix zum Verteilen von Werten von Elementen in jeder Dimension des D-dimensionalen Vektors über wenigstens zwei Dimensionen ist, wobei Konstellationsblöcke jeweils aus D-dimensionalen Vektoren bestehen, die aus den gleichen BxD quasizyklischen Blöcken erzeugt werden;
Zuordnen von NxQ/B transformierten reellen Symbolen zu NxQ/(2xB) komplexen Symbolen, so dass 2xD transformierte relle Symbole für jeden der Konstellationsblöcke zu D komplexen Symbolen zugeordnet sind und die D transformierten reellen Symbole von jeder der D-dimensionalen gedrehten Konstellationen D verschiedenen komplexen Symbolen zugeordnet sind; und
Senden der NxQ/(2xB) komplexen Symbole.

2. Sendeverfahren nach Anspruch 1, wobei
die Bit-Permutation gleichwertig dem Schreiben der (BxD)xQ Bits von jedem der Abschnitte Zeile für Zeile in eine Abschnittspermutationsmatrix mit Q Spalten und BxD Zeilen und Auslesen der (BxD)xQ Bits Spalte für Spalte aus der Abschnittspermutationsmatrix ist.

3. Sendeverfahren nach Anspruch 1, wobei
der Schritt zum Zuordnen der NxQ/B transformierten reellen Symbole zu den NxQ/(2xB) komplexen Symbole so durchgeführt wird, dass die D-transformierten reellen Symbole von jeder der D-dimensionalen gedrehten Konstellationen entweder D realen Komponenten von D aufeinander folgenden komplexen Symbolen oder D imaginären Komponenten von D aufeinander folgenden komplexen Symbolen zugeordnet werden.

4. Sendeverfahren nach Anspruch 1, wobei
der Schritt zum Zuordnen der NxQ/B transformierten reellen Symbole zu den NxQ/(2xB) komplexen Symbole so durchgeführt wird, dass D-transformierte reelle Symbole von jeder der zwei D-dimensionalen gedrehten Konstellationen zu den gleichen D aufeinander folgenden komplexen Symbolen zugeordnet werden, wobei die zwei D-dimensionalen gedrehten Symbole aus aufeinander folgenden Gruppen von Bits, die zum gleichen Abschnitt gehören, erzeugt werden.

5. Empfangsverfahren zum Empfangen eines auf der Basis eines Quasi-Cyclic-Low-Density-Parity-Check-Codierschemas umfassend ein Repeat-Accumulate-Quasi-Cyclic-Low-Density-Parity-Check-Codierschema erzeugten Codeworts in einem D-dimensionale gedrehte Konstellationen verwendenden Kommunikationssystem, wobei das Codewort aus N quasizyklischen Blöcken besteht, die quasizyklischen Blöcke jeweils aus Q Bits bestehen wobei zwei D-dimensionale Vektoren, die aus den gleichen BxD quasizyklischen Blöcken erzeugt werden, einen Konstellationsblock darstellen, die D-dimensionalen Vektoren jeweils aus einem Bit von jedem von M = BxD quasizyklischen Blöcken erzeugt werden und reelle Symbole jeweils durch Zuordnen von B Bits erhalten werden, wobei das Empfangsverfahren die Schritte umfasst zum:
Rückbilden von empfangenen NxQ/(2xB) komplexen Symbolen auf der Basis von (NxQ)/(BxD) D-dimensionalen gedrehten Konstellationen jeweils mit D transformierten reellen Symbolen als Elemente und aus D-dimensionalen Vektoren erzeugt;
Teilen von durch Rückbilden erhaltenen NxQ Bits in N/M = N/(BxD) Abschnitte, wobei N/(BxD) eine Ganzzahl ist und jeder Abschnitt aus M quasizyklischen Blöcken besteht; und
Anwenden einer umgekehrten Bit-Permutation auf MxQ = (BxD)xQ Bits von jedem der Abschnitte, wobei die umgekehrte Bit-Permutation die Umkehrfunktion einer durch einen Sender durchgeführten Bit-Permutation ist.

6. Empfangsverfahren nach Anspruch 5, wobei
die umgekehrte Bit-Permutation gleichwertig dem Schreiben der (BxD)xQ Bits von jedem der Abschnitte Spalte für Spalte in eine Abschnittspermutationsmatrix mit Q Spalten und BxD Zeilen und Auslesen der (BxD)xQ Bits Zeile für Zeile aus der Abschnittspermutationsmatrix ist.

7. Sender zum Senden eines auf der Basis eines Quasi-Cyclic-Low-Density-Parity-Check-Codierschemas umfassend ein Repeat-Accumulate-Quasi-Cyclic-Low-Density-Parity-Check-Codierschema erzeugten Codeworts in einem D-dimensionale gedrehte Konstellationen verwendenden Kommunikationssystem, wobei das Codewort aus N quasizyklischen Blöcken besteht, die quasizyklischen Blöcke jeweils aus Q Bits bestehen und reelle Symbole jeweils durch Zuordnen von B Bits erhalten werden, wobei der Sender umfasst:
einen Bit-Verschachteler zum Teilen des Codeworts in N/(BxD) Abschnitte, wobei N/(BxD) eine Ganzzahl ist, wobei jeder Abschnitt aus M = BxD quasizyklischen Blöcken besteht, Anwenden einer Bit-Permutation auf MxQ = (BxD)xQ Bits von jedem der Abschnitte und Gruppieren der permutierten (BxD)xQ Bits von jedem der Abschnitte zu Q Gruppen von Bits jeweils bestehend aus M Bits, wobei die Bit-Permutation so ausgebildet ist, dass die Q Bits von jedem der quasizyklischen Blöcke Q verschiedenen Gruppen von Bits zugeordnet werden;
einen Konstellationszuordner zum Zuordnen von B Bits von jeder der Gruppen von Bits zu einem reellen Symbol; und
einen Konstellationsdreher zum Transformieren eines D-dimensionalen Vektors mit aus den Gruppen von Bits als Elemente erzeugten D reellen Symbolen in einen D-dimensionalen gedrehten Block mit gedrehter Konstellation mit D transformierten reellen Symbolen als Elemente durch Multiplizieren des D-dimensionalen Vektors durch eine orthogonale Matrix mit D Spalten und D Zeilen, wobei die orthogonale Matrix eine Matrix zum Verteilen von Werten von Elementen in jeder Dimension des D-dimensionalen Vektors über wenigstens zwei Dimensionen ist, wobei Konstellationsblöcke jeweils aus D-dimensionalen Vektoren bestehen, die aus den gleichen BxD quasizyklischen Blöcken erzeugt werden, und Zuordnen von NxQ/B transformierten reellen Symbolen zu NxQ/(2xB) komplexen Symbolen, so dass 2xD transformierte relle Symbole für jeden der Konstellationsblöcke zu D komplexen Symbolen zugeordnet sind und die D transformierten reellen Symbole von jeder der D-dimensionalen gedrehten Konstellationen D verschiedenen komplexen Symbolen zugeordnet sind; und
einen Sender zum Senden der NxQ/(2xB) komplexen Symbole.

8. Empfänger zum Empfangen eines auf der Basis eines Quasi-Cyclic-Low-Density-Parity-Check-Codierschemas umfassend ein Repeat-Accumulate-Quasi-Cyclic-Low-Density-Parity-Check-Codierschema erzeugten Codeworts in einem D-dimensionale gedrehte Konstellationen verwendenden Kommunikationssystem, wobei das Codewort aus N quasizyklischen Blöcken besteht, die quasizyklischen Blöcke jeweils aus Q Bits bestehen wobei zwei D-dimensionale Vektoren, die aus den gleichen BxD quasizyklischen Blöcken erzeugt werden, einen Konstellationsblock darstellen, die D-dimensionalen Vektoren jeweils aus einem Bit von jedem von M = BxD quasizyklischen Blöcken erzeugt werden und reelle Symbole jeweils durch Zuordnen von B Bits erhalten werden, wobei der Empfänger umfasst:
einen Konstellationsrückbilder zum Rückbilden von empfangenen NxQ/(2xB) komplexen Symbolen auf der Basis von (NxQ)/(BxD) D-dimensionalen gedrehten Konstellationen jeweils mit D transformierten reellen Symbolen als Elemente und aus D-dimensionalen Vektoren erzeugt; und
einen Bit-Entschachteler zum Teilen von durch Rückbilden erhaltenen NxQ Bits in N/M = N/(BxD) Abschnitte, wobei N/(BxD) eine Ganzzahl ist, und jeder Abschnitt aus M quasizyklischen Blöcken besteht, und Anwenden einer umgekehrten Bit-Permutation auf MxQ = (BxD)xQ Bits von jedem der Abschnitte, wobei die umgekehrte Bit-Permutation die Umkehrfunktion einer durch einen Sender durchgeführten Bit-Permutation ist.

9. Empfänger nach Anspruch 8, wobei
die umgekehrte Bit-Permutation gleichwertig dem Schreiben der (BxD)xQ Bits von jedem der Abschnitte Spalte für Spalte in eine Abschnittspermutationsmatrix mit Q Spalten und BxD Zeilen und Auslesen der (BxD)xQ Bits Zeile für Zeile aus der Abschnittspermutationsmatrix ist.

10. Empfänger nach Anspruch 8, ferner umfassend
einen ersten Speicher zum Speichern von vom Konstellationsrückbilder ausgegebenen NxQ Bits darin, wobei der erste Speicher in P erste parallele Speicherbänke unterteilt ist und P ein Teiler von Q ist, wobei
der Konstellationsrückbilder eine Vielzahl von Konstellationsrückbildereinheiten umfasst, wobei die Konstellationsrückbilderienheiten in P/2 Rückbilderbänke unterteilt sind und die Rückbilderbänke ausgebildet sind, auf zwei angrenzende der ersten Speicherbänke zuzugreifen.

11. Empfänger nach Anspruch 10, ferner umfassend
einen zweiten Speicher zum Speichern von NxQ/(2xB) komplexen Symbolen darin, wobei der zweite Speicher in P zweite parallele Speicherbänke unterteilt ist, wobei
die Rückbilderbänke jeweils ferner ausgebildet sind, auf zwei angrenzende der zweiten Speicherbänke zuzugreifen.

12. Sendeverfahren zum Senden eines auf der Basis eines Quasi-Cyclic-Low-Density-Parity-Check-Codierschemas umfassend ein Repeat-Accumulate-Quasi-Cyclic-Low-Density-Parity-Check-Codierschema erzeugten Codeworts in einem D-dimensionale gedrehte Konstellationen verwendenden Kommunikationssystem, wobei das Codewort aus N quasizyklischen Blöcken besteht, die quasizyklischen Blöcke jeweils aus Q Bits bestehen und reelle Symbole jeweils durch Zuordnen von B Bits erhalten werden, wobei das Sendeverfahren die Schritte umfasst zum:
Zuordnen von B Bits zu einem reellen Symbol;
Transformieren eines D-dimensionalen Vektors mit als Elemente erzeugten D reellen Symbolen in eine D-dimensionale gedrehte Konstellation mit D transformierten reellen Symbolen als Elemente durch Multiplizieren des D-dimensionalen Vektors durch eine orthogonale Matrix mit D Spalten und D Zeilen, wobei zwei D-dimensionale Vektoren, die aus den gleichen BxD quasizyklischen Blöcken erzeugt werden, einen Konstellationsblock darstellen, die D-dimensionalen Vektoren jeweils aus einem Bit von jedem von BxD quasizyklischen Blöcken erzeugt werden und die orthogonale Matrix eine Matrix zum Verteilen von Werten von Elementen in jeder Dimension des D-dimensionalen Vektors über wenigstens zwei Dimensionen ist;
Teilen von NxQ/B transformierten reellen Symbolen in N/(BxD) Abschnitte, wobei N/(BxD) eine Ganzzahl ist, so dass die D transformierten reellen Symbole des D-dimensionalen Blocks mit gedrehter Konstellation im gleichen Abschnitt enthalten sind, und Anwenden einer ersten Komponentenpermutation auf QxD transformierte reelle Symbole von jedem der Abschnitte, wobei die erste Komponentenpermutation gleichwertig dem Schreiben der QxD transformierten reellen Symbole Spalte für Spalte in eine erste Komponentenpermutationsmatrix mit Q Spalten und D Zeilen, Anwenden einer zyklischen Verschiebung auf jede der Zeilen der ersten Komponentenpermutationsmatrix und Auslesen der zyklisch verschobenen QxD transformierten reellen Symbole Zeile für Zeile aus der ersten Komponentenpermutationsmatrix ist; und
Senden von NxQ/(2xB) komplexen Symbolen jeweils bestehend aus zwei transformierten reellen Symbolen.

13. Sendeverfahren nach Anspruch 12, ferner umfassend den Schritt zum: vor dem Senden der NxQ/(2xB) komplexen Symbole,
Zuordnen von zwei aufeinander folgenden der transformierten reellen Symbole, die der ersten Komponentenpermutation unterzogen werden, zu einem komplexen Symbol, und Anwenden einer Komplexsymbolpermutation auf die NxQ/(2xB) komplexen Symbole, wobei die Komplexsymbolpermutation gleichwertig dem Schreiben der NxQ/(2xB) komplexen Symbole Zeile für Zeile in eine Komplexsymbol-Permutationsmatrix mit Q/2 Spalten und N/B Reihen und Auslesen der geschriebenen NxQ/(2xB) komplexen Symbole Spalte für Spalte aus der Komplexsymbol-Permutationsmatrix ist.

14. Sendeverfahren nach Anspruch 12, ferner umfassend den Schritt zum:
Teilen von durch Zuordnen der B Bits zum reellen Symbol erhaltenen NxQ/B reellen Symbolen in N/(BxD) Abschnitte und Anwenden einer zweiten Komponentenpermutation auf QxD reelle Symbole von jedem der Abschnitte, wobei die zweite Komponentenpermutation gleichwertig dem Schreiben der QxD reellen Symbole Zeile für Zeile in eine zweite Komponentenpermutationsmatrix mit Q Spalten und D Zeilen, Anwenden einer umgekehrten zyklischen Verschiebung auf jede der Zeilen der zweiten Komponentenpermutationsmatrix und Auslesen der zyklisch verschobenen QxD reellen Symbole Spalte für Spalte aus der zweiten Komponentenpermutationsmatrix ist, wobei die umgekehrte zyklische Verschiebung die Umkehrfunktion der in der ersten Komponentenpermutation angewendeten zyklischen Verschiebung ist.

15. Sendeverfahren nach Anspruch 12, wobei
die auf k Zeilen der ersten Komponentenpermutationsmatrix angewendete zyklische Verschiebung kxQ/D ist, wobei k ein Index der Zeile beginnend mit Null ist.

16. Sendeverfahren nach Anspruch 12, wobei
die auf k Zeilen der ersten Komponentenpermutationsmatrix angewendete zyklische Verschiebung eine gerade Ganzzahl ist.

17. Empfangsverfahren zum Empfangen eines auf der Basis eines Quasi-Cyclic-Low-Density-Parity-Check-Codierschemas umfassend ein Repeat-Accumulate-Quasi-Cyclic-Low-Density-Parity-Check-Codierschema erzeugten Codeworts in einem D-dimensionale gedrehte Konstellationen verwendenden Kommunikationssystem, wobei das Codewort aus N quasizyklischen Blöcken besteht, die quasizyklischen Blöcke jeweils aus Q Bits bestehen wobei zwei D-dimensionale Vektoren, die aus den gleichen BxD quasizyklischen Blöcken erzeugt werden, einen Konstellationsblock darstellen, die D-dimensionalen Vektoren jeweils aus einem Bit von jedem von M = BxD quasizyklischen Blöcken erzeugt werden und reelle Symbole jeweils durch Zuordnen von B Bits erhalten werden, wobei das Empfangsverfahren die Schritte umfasst zum:
Teilen von NxQ/B Komponenten auf der Basis von NxQ/(2xB) komplexen Symbolen in N/(BxD) Abschnitte, wobei N/(BxD) eine Ganzzahl ist, so dass D Komponenten, die D transformierten reellen Symbolen eines D-dimensionalen Blocks mit gedrehter Konstellation im gleichen Abschnitt enthalten sind, und Anwenden einer Komponentenpermutation auf QxD Komponenten von jedem der Abschnitte, wobei die Komponentenpermutation gleichwertig dem Schreiben der QxD Komponenten Zeile für Zeile in eine Komponentenpermutationsmatrix mit Q Spalten und D Zeilen, Anwenden einer umgekehrten zyklischen Verschiebung auf jede der Zeilen der Komponentenpermutationsmatrix und Auslesen der zyklisch verschobenen QxD Komponenten Spalte für Spalte aus der Komponentenpermutationsmatrix ist, wobei die umgekehrte zyklische Verschiebung die Umkehrfunktion einer durch einen Sender durchgeführten zyklischen Verschiebung ist; und
Rückbilden von NxQ/(2xB) komplexen Symbolen, die der Komponentenpermutation unterzogen wurden, auf der Basis von (NxQ)/(BxD) D-dimensionalen gedrehten Konstellationen jeweils mit D transformierten reellen Symbolen als Elemente und aus D-dimensionalen Vektoren erzeugt.

18. Sender zum Senden eines auf der Basis eines Quasi-Cyclic-Low-Density-Parity-Check-Codierschemas umfassend ein Repeat-Accumulate-Quasi-Cyclic-Low-Density-Parity-Check-Codierschema erzeugten Codeworts in einem D-dimensionale gedrehte Konstellationen verwendenden Kommunikationssystem, wobei das Codewort aus N quasizyklischen Blöcken besteht, die quasizyklischen Blöcke jeweils aus Q Bits bestehen und reelle Symbole jeweils durch Zuordnen von B Bits erhalten werden, wobei der Sender umfasst:
einen Konstellationszuordner zum Zuordnen von B Bits zu einem reellen Symbol;
einen Konstellationsdreher zum Transformieren eines D-dimensionalen Vektors mit als Elemente erzeugten D reellen Symbolen in einen D-dimensionalen Block mit gedrehter Konstellation mit D transformierten reellen Symbolen als Elemente durch Multiplizieren des D-dimensionalen Vektors durch eine orthogonale Matrix mit D Spalten und D Zeilen, wobei zwei D-dimensionale Vektoren, die aus den gleichen BxD quasizyklischen Blöcken erzeugt werden, einen Konstellationsblock darstellen, die D-dimensionalen Vektoren jeweils aus einem Bit von jedem von BxD quasizyklischen Blöcken erzeugt werden und die orthogonale Matrix eine Matrix zum Verteilen von Werten von Elementen in jeder Dimension des D-dimensionalen Vektors über wenigstens zwei Dimensionen ist;
einen Komponentenverschachteler zum Teilen von NxQ/B transformierten reellen Symbolen in N/(BxD) Abschnitte, wobei N/(BxD) eine Ganzzahl ist, so dass die D transformierten reellen Symbole der D-dimensionalen gedrehten Konstellation im gleichen Abschnitt enthalten sind, und Anwenden einer ersten Komponentenpermutation auf QxD transformierte reelle Symbole von jedem der Abschnitte, wobei die erste Komponentenpermutation gleichwertig dem Schreiben der QxD transformierten reellen Symbole Spalte für Spalte in eine erste Komponentenpermutationsmatrix mit Q Spalten und D Zeilen, Anwenden einer zyklischen Verschiebung auf jede der Zeilen der ersten Komponentenpermutationsmatrix und Auslesen der zyklisch verschobenen QxD transformierten reellen Symbole Zeile für Zeile aus der ersten Komponentenpermutationsmatrix ist; und
einen Sender zum Senden von NxQ/(2xB) komplexen Symbolen jeweils bestehend aus zwei transformierten reellen Symbolen.

19. Empfänger zum Empfangen eines auf der Basis eines Quasi-Cyclic-Low-Density-Parity-Check-Codierschemas umfassend ein Repeat-Accumulate-Quasi-Cyclic-Low-Density-Parity-Check-Codierschema erzeugten Codeworts in einem D-dimensionale gedrehte Konstellationen verwendenden Kommunikationssystem, wobei das Codewort aus N quasizyklischen Blöcken besteht, die quasizyklischen Blöcke jeweils aus Q Bits bestehen wobei zwei D-dimensionale Vektoren, die aus den gleichen BxD quasizyklischen Blöcken erzeugt werden, einen Konstellationsblock darstellen, die D-dimensionalen Vektoren jeweils aus einem Bit von jedem von M = BxD quasizyklischen Blöcken erzeugt werden und reelle Symbole jeweils durch Zuordnen von B Bits erhalten werden, wobei der Empfänger umfasst:
einen Komponentenentschachteler zum Teilen von NxQ/B Komponenten auf der Basis von NxQ/(2xB) komplexen Symbolen in N/(BxD) Abschnitte, wobei N/(BxD) eine Ganzzahl ist, so dass D Komponenten, die D transformierten reellen Symbolen einer D-dimensionalen gedrehten Konstellation im gleichen Abschnitt enthalten sind, und Anwenden einer Komponentenpermutation auf QxD Komponenten von jedem der Abschnitte, wobei die Komponentenpermutation gleichwertig dem Schreiben der QxD Komponenten Zeile für Zeile in eine Komponentenpermutationsmatrix mit Q Spalten und D Zeilen, Anwenden einer umgekehrten zyklischen Verschiebung auf jede der Zeilen der Komponentenpermutationsmatrix und Auslesen der zyklisch verschobenen QxD Komponenten Spalte für Spalte aus der Komponentenpermutationsmatrix ist, wobei die umgekehrte zyklische Verschiebung die Umkehrfunktion einer durch einen Sender durchgeführten zyklischen Verschiebung ist; und
einen Drehkonstellations-Rückbilder zum Rückbilden von NxQ/(2xB) komplexen Symbolen, die der Komponentenpermutation unterzogen wurden, auf der Basis von (NxQ)/(BxD) D-dimensionalen gedrehten Konstellationen jeweils mit D transformierten reellen Symbolen als Elemente und aus D-dimensionalen Vektoren erzeugt.

## Revendications

1. Procédé de transmission pour transmettre, dans un système de communication employant des constellations de rotation de dimension D, un mot de code généré selon un schéma de codage de contrôle de parité à faible densité quasi-cyclique incluant un schéma de codage de contrôle de parité à faible densité quasi-cyclique par accumulation répétée, le mot de code consistant en N blocs quasi-cycliques, les blocs quasi-cycliques consistant chacun en Q bits, et des symboles à valeur réelle étant chacun obtenus par un mappage de B bits, le procédé de transmission comprenant les étapes de :
division du mot de code en N/(BxD) sections, N/(BxD) étant un nombre entier, chaque section consistant en M = BxD blocs quasi-cycliques, appliquant une permutation de bits à MxQ = (BxD)xQ bits de chacune des sections, et groupant les bits permutés de chacune des sections en Q groupes de bits chacun consistant en M bits, la permutation de bits étant adaptée de sorte que les Q bits de chacun des blocs quasi-cycliques soient mappés sur Q groupes différents de bits ;
mappage de B bits de chacun des groupes de bits sur un symbole à valeur réelle ;
transformation d'un vecteur de dimension D présentant D symboles à valeur réelle générés à partir des groupes de bits en tant qu'éléments dans un bloc de constellation de rotation de dimension D présentant D symboles à valeur réelle transformés en tant qu'éléments en multipliant le vecteur de dimension D par une matrice orthogonale à D colonnes et D rangées, la matrice orthogonale étant une matrice pour un étalement de valeurs d'éléments dans chaque dimension du vecteur de dimension D sur au moins deux dimensions, des blocs de constellation consistant chacun en des vecteurs de dimension D qui sont générés à partir des mêmes BxD blocs quasi-cycliques ;
mappage de NxQ/B symboles à valeur réelle transformés en NxQ/(2xB) symboles complexes de sorte que 2xD symboles à valeur réelle transformés pour chacun des blocs de constellation soient mappés sur D symboles complexes et les D symboles à valeur réelle transformés de chacune des constellations de rotation de dimension D soient mappés sur D symboles complexes différents ; et
Transmission des NxQ/(2xB) symboles complexes.

2. Le procédé de transmission selon la revendication 1, dans lequel
la permutation de bits est équivalente à une écriture des (BxD)xQ bits de chacune des sections rangée par rangée dans une matrice de permutation de sections à Q colonnes et BxD rangées et une lecture des (BxD)xQ bits écrits colonne par colonne à partir de la matrice de permutation de sections.

3. Le procédé de transmission selon la revendication 1, dans lequel
l'étape de mappage des NxQ/B symboles à valeur réelle transformés sur les NxQ/(2xB) symboles complexes s'effectue de sorte que les D symboles à valeur réelle transformés de chacune des constellations de rotation de dimension D soient mappés soit sur D composants réels de D symboles complexes consécutifs, soit sur D composants imaginaires de D symboles complexes consécutifs.

4. Le procédé de transmission selon la revendication 1, dans lequel
l'étape de mappage des NxQ/B symboles à valeur réelle transformés sur les NxQ/(2xB) symboles complexes s'effectue de sorte que D symboles à valeur réelle transformés de chacune de deux constellations de rotation de dimension D soient mappés sur les mêmes D symboles complexes consécutifs, les deux constellations de rotation de dimension D étant générées à partir de groupes consécutifs de bits appartenant à la même section.

5. Procédé de réception pour recevoir, dans un système de communication employant des constellations de rotation de dimension D, un mot de code généré selon un schéma de codage de contrôle de parité à faible densité quasi-cyclique incluant un schéma de codage de contrôle de parité à faible densité quasi-cyclique par accumulation répétée, le mot de code consistant en N blocs quasi-cycliques, les blocs quasi-cycliques consistant chacun en Q bits, deux vecteurs de dimension D qui sont générés à partir des mêmes BxD blocs cycliques constituant un bloc de constellation, les vecteurs de dimension D étant chacun générés à partir d'un bit de chacun des M = BxD blocs quasi-cylindriques, et des symboles à valeur réelle étant chacun obtenus par un mappage de B bits, le procédé de réception comprenant les étapes de :
démappage de NxQ/(2xB) symboles complexes reçus selon (NxQ)/(BxD) constellations de rotation de dimension D chacune présentant D symboles à valeur réelle transformés en tant qu'éléments et étant générée à partir de vecteurs de dimension D ;
division de NxQ bits obtenus par le démappage en N/M = N/(BxD) sections, N/(BxD) étant un nombre entier, chaque section consistant en M blocs quasi-cycliques ; et
application d'une permutation de bits inverse à MxQ = (BxD)xQ bits de chacune des sections, la permutation de bits inverse étant l'inverse d'une permutation de bits effectuée par l'émetteur.

6. Le procédé de réception selon la revendication 5, dans lequel
la permutation de bits inverse est équivalente à une écriture des (BxD)xQ bits de chacune des sections colonne par colonne dans une matrice de permutation de sections à Q colonnes et BxD rangées et une lecture des (BxD)xQ bits écrits rangée par rangée à partir de la matrice de permutation de sections.

7. Émetteur pour transmettre, dans un système de communication employant des constellations de rotation de dimension D, un mot de code généré selon un schéma de codage de contrôle de parité à faible densité quasi-cyclique incluant un schéma de codage de contrôle de parité à faible densité quasi-cyclique par accumulation répétée, le mot de code consistant en N blocs quasi-cycliques, les blocs quasi-cycliques consistant chacun en Q bits, et des symboles à valeur réelle étant chacun obtenus par un mappage de B bits, l'émetteur comprenant :
un entrelaceur de bits divisant le mot de code en N/(BxD) sections, N/(BxD) étant un nombre entier, chaque section consistant en M = BxD blocs quasi-cycliques, appliquant une permutation de bits à MxQ = (BxD)xQ bits de chacune des sections, et groupant les (BxD)xQ bits permutés de chacune des sections en Q groupes de bits chacun consistant en M bits, la permutation de bits étant adaptée de sorte que les Q bits de chacun des blocs quasi-cycliques soient mappés sur Q groupes différents de bits ;
un mappeur de constellation mappant B bits de chacun des groupes de bits sur un symbole à valeur réelle ; et
un rotateur de constellation transformant un vecteur de dimension D présentant D symboles à valeur réelle générés à partir des groupes de bits en tant qu'éléments en un bloc de constellation de rotation de dimension D présentant D symboles à valeur réelle transformés en tant qu'éléments en multipliant le vecteur de dimension D par une matrice orthogonale à D colonnes et D rangées, la matrice orthogonale étant une matrice pour un étalement de valeurs d'éléments dans chaque dimension du vecteur de dimension D sur au moins deux dimensions, des blocs de constellation consistant chacun en des vecteurs de dimension D qui sont générés à partir des mêmes BxD blocs quasi-cycliques, et mappant NxQ/B symboles à valeur réelle transformés sur NxQ/(2xB) symboles complexes de sorte que 2xD symboles à valeur réelle transformés pour chacun des blocs de constellation soient mappés sur D symboles complexes et les D symboles à valeur réelle transformés de chacune des constellations de rotation de dimension D soient mappés sur D symboles complexes différents ; et
un émetteur émettant les NxQ/(2xB) symboles complexes.

8. Récepteur pour recevoir, dans un système de communication employant des constellations de rotation de dimension D, un mot de code généré selon un schéma de codage de contrôle de parité à faible densité quasi-cyclique incluant un schéma de codage de contrôle de parité à faible densité quasi-cyclique par accumulation répétée, le mot de code consistant en N blocs quasi-cycliques, les blocs quasi-cycliques consistant chacun en Q bits, deux vecteurs de dimension D qui sont générés à partir des mêmes BxD blocs cycliques constituant un bloc de constellation, les vecteurs de dimension D étant chacun générés à partir d'un bit de chacun des M = BxD blocs quasi-cylindriques, et des symboles à valeur réelle étant chacun obtenus par un mappage de B bits, le récepteur comprenant :
un démappeur de constellation démappant NxQ/(2xB) symboles complexes reçus selon (NxQ)/(2xB) constellations de rotation de dimension D chacune présentant D symboles à valeur réelle transformés en tant qu'éléments et étant générée à partir de vecteurs de dimension D ; et
un désentrelaceur de bits divisant NxQ bits obtenus par le démappage en N/M = N/(BxD) sections, N/(BxD) étant un nombre entier, chaque section consistant en M blocs quasi-cycliques, et appliquant une permutation de bits inverse à MxQ = (BxD)xQ bits de chacune des sections, la permutation de bits inverse étant l'inverse d'une permutation de bits effectuée par un émetteur.

9. Le récepteur selon la revendication 8, dans lequel
la permutation de bits inverse est équivalente à une écriture des (BxD)xQ bits de chacune des sections colonne par colonne dans une matrice de permutation de sections à Q colonnes et BxD rangées et une lecture des (BxD)xQ bits écrits rangée par rangée à partir de la matrice de permutation de sections.

10. Le récepteur selon la revendication 8, comprenant en outre
une première mémoire stockant en son sein NxQ bits sortis du démappeur de constellation, la première mémoire étant divisée en P premières banques de mémoire en parallèle, P étant un diviseur de Q, dans lequel
le démappeur de constellation inclut une pluralité d'unités de démappeur de constellation, les unités de démappeur de constellation étant divisées en P/2 banques de démappeurs, les banques de démappeurs étant chacune configurées pour accéder à deux adjacentes des premières banques de mémoire.

11. Le récepteur selon la revendication 10, comprenant en outre
une deuxième mémoire stockant en son sein NxQ/(2xB) symboles complexes, la deuxième mémoire étant divisée en P deuxièmes banques de mémoire en parallèle, dans lequel
les banques de démappeurs sont chacun configurées en outre pour accéder à deux adjacentes des deuxièmes banques de mémoire.

12. Procédé de transmission pour transmettre, dans un système de communication employant des constellations de rotation de dimension D, un mot de code généré selon un schéma de codage de contrôle de parité à faible densité quasi-cyclique incluant un schéma de codage de contrôle de parité à faible densité quasi-cyclique par accumulation répétée, le mot de code consistant en N blocs quasi-cycliques, les blocs quasi-cycliques consistant chacun en Q bits, et des symboles à valeur réelle étant chacun obtenus par un mappage de B bits, le procédé de transmission comprenant les étapes de :
mappage de B bits en un symbole à valeur réelle ;
transformation d'un vecteur de dimension D présentant D symboles à valeur réelle en tant qu'éléments en une constellation de rotation de dimension D présentant D symboles à valeur réelle transformés en tant qu'éléments en multipliant le vecteur de dimension D par une matrice orthogonale à D colonnes et D rangées, deux vecteurs de dimension D qui sont générés à partir des mêmes BxD blocs quasi-cycliques constituant un bloc de constellation, les vecteurs de dimension D étant chacun générés à partir d'un bit de chacun des BxD blocs quasi-cycliques, la matrice orthogonale étant une matrice pour un étalement de valeurs d'éléments dans chaque dimension du vecteur de dimension D sur au moins deux dimensions ;
division de NxQ/B symboles à valeur réelle transformés en N/(BxD) sections, N/(BxD) étant un nombre entier, de sorte que les D symboles à valeur réelle transformés du bloc de constellation de rotation de dimension D soient inclus dans la même section, et application d'une première permutation de composants à QxD symboles à valeur réelle transformés de chacune des sections, la première permutation de composants étant équivalente à une écriture des QxD symboles à valeur réelle transformés colonne par colonne dans une première matrice de permutation de composants à Q colonnes et D rangées, application d'un basculement cyclique à chacune des rangées de la première matrice de permutation de composants, et lecture des QxD symboles à valeur réelle transformés cycliquement basculés rangée par rangée à partir de la première matrice de permutation de composants ; et
transmission de NxQ/(2xB) symboles complexes chacun consistant en deux symboles à valeur réelle transformés.

13. Le procédé de transmission selon la revendication 12, comprenant en outre l'étape de :
avant transmission des NxQ/(2xB) symboles complexes,
mappage de deux consécutifs des symboles à valeur réelle transformés, qui ont fait l'objet de la première permutation de composants, sur un symbole complexe, et application d'une permutation de symboles complexes aux NxQ/(2xB) symboles complexes, la permutation de symboles complexes étant équivalente à une écriture des NxQ/(2xB) symboles complexes rangée par rangée dans une matrice de permutation de symboles complexes à Q/2 colonnes et N/B rangées et une lecture des NxQ/(2xB) symboles complexes écrits colonne par colonne à partir de la matrice de permutation de symboles complexes.

14. Le procédé de transmission selon la revendication 12, comprenant en outre l'étape de :
division de NxQ/B symboles à valeur réelle obtenus par un mappage des B bits sur le symbole à valeur réelle dans N/(BxD) sections, et application d'une deuxième permutation de composants à QxD symboles à valeur réelle de chacune des sections, la deuxième permutation de composants étant équivalente à une écriture des QxD symboles à valeur réelle rangée par rangée dans une deuxième matrice de permutation de composants à Q colonnes et D rangées, application d'un basculement cyclique inverse à chacune des rangées de la deuxième matrice de permutation de composants, et lecture des QxD symboles à valeur réelle cycliquement basculés colonne par colonne à partir de la deuxième matrice de permutation de composants, le basculement cyclique inverse étant l'inverse du basculement cyclique appliqué dans la première permutation de composants.

15. Le procédé de transmission selon la revendication 12, dans lequel
le basculement cyclique appliqué à k rangées de la première matrice de permutation de composants est kxQ/D, k étant un index de la rangée commençant par zéro.

16. Le procédé de transmission selon la revendication 12, dans lequel
le basculement cyclique appliqué à k rangées de la première matrice de permutation de composants est un nombre entier pair.

17. Procédé de réception pour recevoir, dans un système de communication employant des constellations de rotation de dimension D, un mot de code généré selon un schéma de codage de contrôle de parité à faible densité quasi-cyclique incluant un schéma de codage de contrôle de parité à faible densité quasi-cyclique par accumulation répétée, le mot de code consistant en N blocs quasi-cycliques, les blocs quasi-cycliques consistant chacun en Q bits, deux vecteurs de dimension D qui sont générés à partir des mêmes BxD blocs cycliques constituant un bloc de constellation, les vecteurs de dimension D étant chacun générés à partir d'un bit de chacun des M = BxD blocs quasi-cylindriques, et des symboles à valeur réelle étant chacun obtenus par un mappage de B bits, le procédé de réception comprenant les étapes de :
division de NxQ/B composants selon NxQ/(2xB) en N/(BxD) sections, N/(BxD) étant un nombre entier, de sorte que D composants qui correspondent à D symboles à valeur réelle transformés d'un bloc de constellation de rotation de dimension D soient inclus dans la même section, et application d'une permutation de composants à QxD composants de chacune des sections, la permutation de composants étant équivalente à une écriture des QxD composants rangée par rangée dans une matrice de permutation de composants à Q colonnes et D rangées, application d'un basculement cyclique inverse à chacune des rangées de la matrice de permutation de composants, et lecture des QxD composants cycliquement basculés colonne par colonne à partir de la matrice de permutation de composants, le basculement cyclique inverse étant l'inverse d'un basculement cyclique effectué par un émetteur ; et
démappage de NxQ/(2xB) symboles complexes qui ont fait l'objet de la permutation de composants, selon (NxQ)/(BxD) constellations de rotation de dimension D chacune présentant D symboles à valeur réelle transformés en tant qu'éléments et étant générée à partir de vecteurs de dimension D.

18. Émetteur pour transmettre, dans un système de communication employant des constellations de rotation de dimension D, un mot de code généré selon un schéma de codage de contrôle de parité à faible densité quasi-cyclique incluant un schéma de codage de contrôle de parité à faible densité quasi-cyclique par accumulation répétée, le mot de code consistant en N blocs quasi-cycliques, les blocs quasi-cycliques consistant chacun en Q bits, et des symboles à valeur réelle étant chacun obtenus par un mappage de B bits, l'émetteur comprenant :
un mappeur de constellation mappant B bits en un symbole à valeur réelle ;
un rotateur de constellation transformant un vecteur de dimension D présentant D symboles à valeur réelle en tant qu'éléments en une constellation de rotation de dimension D présentant D symboles à valeur réelle transformés en tant qu'éléments en multipliant le vecteur de dimension D par une matrice orthogonale à D colonnes et D rangées, deux vecteurs de dimension D qui sont générés à partir des mêmes BxD blocs quasi-cycliques constituant un bloc de constellation, les vecteurs de dimension D étant chacun générés à partir d'un bit de chacun des BxD blocs quasi-cycliques, la matrice orthogonale étant une matrice pour un étalement de valeurs d'éléments dans chaque dimension du vecteur de dimension D sur au moins deux dimensions ;
un entrelaceur de composants divisant NxQ/B symboles à valeur réelle transformés en N/(BxD) sections, N/(BxD) étant un nombre entier, de sorte que les D symboles à valeur réelle transformés de la constellation de rotation de dimension D soient inclus dans la même section, et application d'une première permutation de composants à QxD symboles à valeur réelle transformés de chacune des sections, la première permutation de composants étant équivalente à une écriture des QxD symboles à valeur réelle transformés colonne par colonne dans une première matrice de permutation de composants à Q colonnes et D rangées, application d'un basculement cyclique à chacune des rangées de la première matrice de permutation de composants, et lecture des QxD symboles à valeur réelle transformés cycliquement basculés rangée par rangée à partir de la première matrice de permutation de composants ; et
un émetteur transmettant NxQ/(2xB) symboles complexes chacun consistant en deux symboles à valeur réelle transformés.

19. Récepteur pour recevoir, dans un système de communication employant des constellations de rotation de dimension D, un mot de code généré selon un schéma de codage de contrôle de parité à faible densité quasi-cyclique incluant un schéma de codage de contrôle de parité à faible densité quasi-cyclique par accumulation répétée, le mot de code consistant en N blocs quasi-cycliques, les blocs quasi-cycliques consistant chacun en Q bits, deux vecteurs de dimension D qui sont générés à partir des mêmes BxD blocs cycliques constituant un bloc de constellation, les vecteurs de dimension D étant chacun générés à partir d'un bit de chacun des M = BxD blocs quasi-cylindriques, et des symboles à valeur réelle étant chacun obtenus par un mappage de B bits, le récepteur comprenant :
un désentrelaceur de composants divisant NxQ/B composants selon NxQ/(2xB) en N/(BxD) sections, N/(BxD) étant un nombre entier, de sorte que D composants qui correspondent à D symboles à valeur réelle transformés d'une constellation de rotation de dimension D soient inclus dans la même section, et application d'une permutation de composants à QxD composants de chacune des sections, la permutation de composants étant équivalente à une écriture des QxD composants rangée par rangée dans une matrice de permutation de composants à Q colonnes et D rangées, application d'un basculement cyclique inverse à chacune des rangées de la matrice de permutation de composants, et lecture des QxD composants cycliquement basculés colonne par colonne à partir de la matrice de permutation de composants, le basculement cyclique inverse étant l'inverse d'un basculement cyclique effectué par un émetteur ; et
un démappeur de constellation de rotation démappant NxQ/(2xB) symboles complexes qui ont fait l'objet de la permutation de composants, selon (NxQ)/(BxD) constellations de rotation de dimension D chacune présentant D symboles à valeur réelle transformés en tant qu'éléments et étant générée à partir de vecteurs de dimension D.
